(19) **Europäisches Patentamt**

**European Patent Office**

**Office européen des brevets**

(11) **EP 0 877 271 B1**

(12) **EUROPEAN PATENT SPECIFICATION**

(45) Date of publication and mention
of the grant of the patent:
**22.12.2004 Bulletin 2004/52**

(51) Int Cl.⁷: **G02B 13/14**, G02B 13/22,
G03F 7/20

(21) Application number: **97117078.2**

(22) Date of filing: **01.10.1997**

(54) **A projection optical system and method of using such system for manufacturing devices**

Optisches Projektionssystem und Verfahren zu dessen Anwendung bei der Herstellung von
Vorrichtungen

Système optique de projection et méthode pour fabriquer des dispositifs à l'aide de ce système

(84) Designated Contracting States:
**DE NL**

(30) Priority: **25.04.1997 JP 10974697**

(43) Date of publication of application:
**11.11.1998 Bulletin 1998/46**

(73) Proprietor: **Nikon Corporation**
**Tokyo 140 (JP)**

(72) Inventors:
• **Suenaga,Yataka,**
**c/o Nikon Corp.,Intell.Prop.Hdq.**
**Chiyoda-ku, Tokyo (JP)**

• **Yamaguchi,Kotaro,**
**c/o Nikon Corp.Intell.Prop.Hdq.**
**Chiyoda-ku, Tokyo (JP)**

(74) Representative: **Wagner, Karl H., Dipl.-Ing.**
**WAGNER & GEYER**
**Patentanwälte**
**Gewürzmühlstrasse 5**
**80538 München (DE)**

(56) References cited:
**EP-A- 0 299 474          EP-A- 0 732 605**

Remarks:
The file contains technical information submitted
after the application was filed and not included in this
specification

## EP 0 877 271 B1

## BACKGROUND OF THE INVENTION

The present invention relates to a projection optical system for projecting a first object pattern onto a second object substrate for device manufacture. More specifically, the present invention relates to a projection optical system which is suitable to superimposingly photoprint a pattern formed on a first object reticle (mask) for semiconductor or liquid crystal display onto a substrate (e.g., wafer, plate, etc.) as a second object.

As integrated circuits become more miniaturized, specifications for higher performance have been required for projection optical systems used for photoprinting a wafer. To improve resolution for projection optical systems, it has been proposed that shorter $\lambda$ exposure light be used, or to utilize a larger numerical aperture (NA) of the projection optical system.

In recent years, in order to meet the miniaturization of printing patterns, a light source which emits from g-line(436 nm) through i-line (365 nm) has been popularly used. A light source which emits light of shorter wavelength such as excimer laser (KrF: 248 nm; ArF: 193 nm) is about to be used. Consequently, projection optical systems have been proposed which use exposure light of the above-mentioned wavelength to superimposingly photoprint a pattern from a reticle onto a wafer.

In a projection optical system, it is required that both resolution be improved and levels of image distortion be decreased. The image distortion includes not only the distortion caused by the projection optical system (distortional aberration), but also distortion due to a warped wafer onto which an image is photoprinted on the image side. Also, distortion may be caused by a warped reticle onto which a circuit pattern and the like is drawn on the object side.

The miniaturization has been further advanced lately and the demand for decreasing image distortion has also grown greatly.

Conventionally, a so-called "image-side telecentric optical system" has been developed. This system locates a point of an exit pupil of the optical system at a farther point on the image side in order to decrease the impact of a warped wafer on the image distortion.

It has also been proposed to use a so-called "object side telecentric optical system," which locates a point of an entrance pupil of the optical system at a farther point from the object side. There are also proposals in which techniques to locate the entrance pupil of a projection optical system relatively farther from the object surface are introduced. Japanese patents S63-118115, H4-157412, and H5-173065, etc. are some of these examples.

In the above-mentioned Japanese patents, the so-called "bitelecentric" projection optical system" having a telecentric object side and a telecentric image side is disclosed.

Nevertheless, the numerical aperture (NA), which effects resolution, is not large enough and aberration correction capability for each of the aberrations, specifically distortion, is not satisfactory for the bitelecentric projection optical system proposed in each of the above patents.

A projection optical system is taught in EP 0732605A, EP 1092130A, EP 0828172A and EP 0828171A, respectively disclosing a first through fifth lens group. However, these disclosures do not teach a fifth lens group having a subgroup G-5p with at least five positive lenses and a positive lens G-5p which is closer to the second object side than the subgroup G-5p much less having a concave surface R-5g facing the second object side and having first, second and third concave surfaces which satisfy certain radius of curvature conditions.

## SUMMARY OF THE INVENTION

An object of the invention is to provide a high performance projection optical system having a large numerical aperture and wide exposure region which is capable of highly accurately correcting various aberrations, specifically distortion, with bitelecentricity.

To achieve the above-mentioned object, a preferred embodiment of the present invention includes a projection optical system in which an image of a first object is printed onto a second object, and comprises in order from the first object side:

a first lens group having a positive refractive power with at least three positive lenses;

a second lens group having a negative refractive power with at least three negative lenses and one positive lens;

a third lens group having a positive refractive power with at least three positive lenses and one negative lens;

a fourth lens group having a negative refractive power with at least three negative lenses; and

2

a fifth lens group having a positive refiactive power with at least six positive lenses and one negative lens

characterized in that:

the first lens group has a subgroup G-1p having at least two positive lenses;

the second lens group has a subgroup G-2n having eat least three negative lenses; the third lens group has a subgroup G-3p having at least three positive lenses;

the fourth lens group has as subgroup G4n having at least three negative lenses;

the fifth lens group has a subgroup G-5p having at least five positive lenses and a positive lens G5g with a concave surface R5g facing the second object side and being closer to the second object side than the subgroup G-5p the fifth lens group further having a first concave surface N1 facing the first object side, a second concave surface N2 facing the second object side, and a third concave surface N3 facing the second object side, the third concave surface N3, being closer to the second object side than the second concave surface N2, and the first, the second, and the third concave surfaces being formed on negative lenses;

wherein, the system satisfies the following conditions:

$$0.08 < f1/L < 0.25$$

$$0.03 < f2/L < 0.1$$

$$0.08 < f3/L < 03$$

$$0.035 < -f4/L < 0.11$$

$$0.1 < f5p/L < 0.25$$

$$0.07 < f5g/L < 0.21$$

$$0.25 < R5g/L < 0.83$$

$$0.125 < -Rn1/L < 0.33$$

$$0.16 < Rn2/L < 0.38$$

$$0.055 < Rn3/L < 0.09$$

where
L is the distance from the first object of the second object;
f1 is the focal length of the subgroup G-1p of the first lens group;
f2 is the focal length of the subgroup G-2n of the second lens group;
f3 is the focal length of the subgroup G-3p of the third lens group;
f4 is the focal length of the subgroup G-4n of the fourth lens group;
f5p is the focal length of the subgroup G5p of the fifth lens group;
R5g is the radius of curvature of the concave surface of the positive lens G5g facing the second object side;

Rn1 is the radius of the curvature of the first concave surface N1;
Rn2 is the radius of curvature of the second concave surface N2; and
Rn3 is the radius of curvature of the third concave surface N3.

**BRIEF DESCRIPTION OF THE DRAWINGS**

The above and other objects, features, and advantages of the present invention will become more apparent from the following description when taken in conjunction with the accompanying drawings, in which:

Figure 1 is a perspective schematic view of an embodiment in which the projection exposure system incorporating the principles of the present invention is applied to a step-and-repeat type projection exposure apparatus;
Figure 2 is a perspective schematic view of an embodiment in which the projection exposure system incorporating the principles of the present invention is applied to a step-and-scan type projection exposure apparatus;
Figure 3 is the lens layout of a projection optical system of Embodiment 1 of the present invention;
Figure 4 is a longitudinal aberration diagram for the projection optical system of Embodiment 1;
Figure 5 is a transverse aberration diagram for the projection optical system of Embodiment 1;
Figure 6 is the lens layout of a projection optical system of Embodiment 2 of the present invention;
Figure 7 is a longitudinal aberration diagram for the projection optical system of Embodiment 2;
Figure 8 is a transverse aberration diagram for the projection optical system of Embodiment 2;
Figure 9 is the lens layout of a projection optical system of Embodiment 3 of the present invention;
Figure 10 is a longitudinal aberration diagram for the projection optical system of Embodiment 3;
Figure 11 is a transverse aberration diagram for the projection optical system of Embodiment 3.
Figure 12 is the lens layout of a projection optical system of Embodiment 4 of the present invention;
Figure 13 is a longitudinal aberration diagram for the projection optical system of Embodiment 4; and
Figure 14 is a transverse aberration diagram for the projection optical system of Embodiment 4.

**DESCRIPTION OF THE PREFERRED EMBODIMENTS**

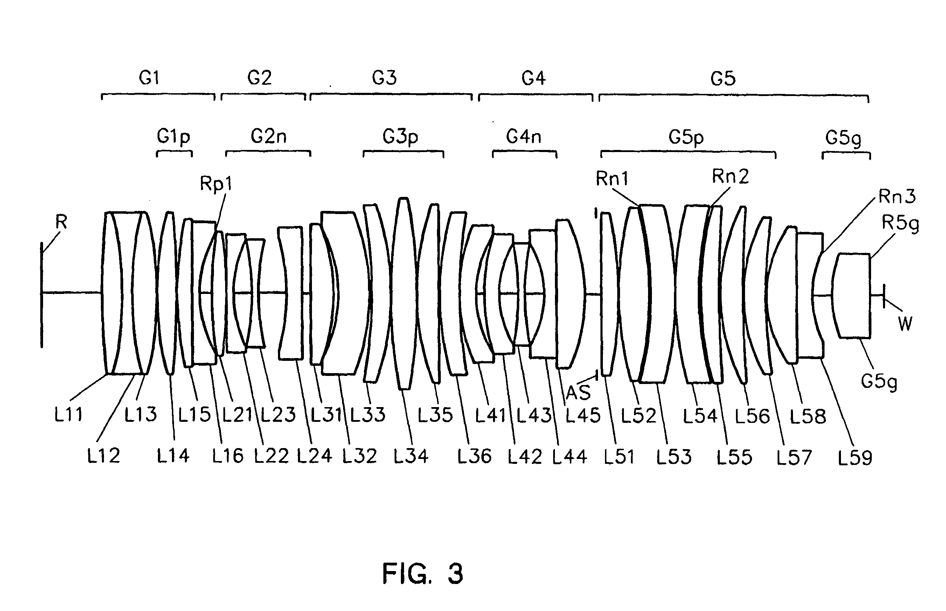

To understand the optics of the projection optical system incorporating the principles of the present invention, refer to Figure 3. The present invention is configured such that the projection optical system has at least, in order from the first object side (reticle R):

a first lens group G1 having a positive refractive power;
a second lens group G2 having a negative refractive;
a third lens group G3 having a positive refractive;
a fourth lens group G4 having a negative refractive power; and
a fifth lens group G5 having a positive refractive power.

The first lens group G1, having a positive refractive power, guides the telecentric beam (which has a principal ray parallel to the optical axis of the projection optical system) emitted from the first object to the lens groups behind the second lens group, G2, and generates positive distortions in advance to correct negative distortions generated by the following lens groups, especially the second, the fourth, and the fifth lens groups, which are arranged closer to the second object side than the first lens group G1.

Also, the third lens group G3, having a positive refractive power, generates positive distortions to correct negative distortions generated by the second, the fourth, and the fifth lens groups, G2, G4, and G5, respectively. When viewed from the second object side (right-hand side in Figure 3), the third lens group G3 and the second lens group G2 form a telephoto system having refractive powers in a positive-negative arrangement which prevents the entire length of the projection lens system from becoming large in order to provide the desired correction.

The second and the fourth lens group G2 and G4, having negative refractive powers, contribute greatly toward correcting the Petzval sum to provide a flat image.

The fifth lens group G5, having a positive refractive power, is responsible for guiding the beam to the second object for imaging while minimizing spherical aberrations.

Next equations utilized to optimize the overall optics are described herein. As described, the projection optical system incorporating the principles of the present invention is constructed to satisfy the following conditions (1) through (7).

$$0.08 < f1 / L < 0.25 \qquad\qquad (1)$$

$$0.03 < -f2 / L < 0.1 \tag{2}$$

$$0.08 < f3 / L < 0.3 \tag{3}$$

$$0.035 < -f4 / L < 0.11 \tag{4}$$

$$0.1 < f5p / L < 0.25 \tag{5}$$

$$0.07 < f5g / L < 0.21 \tag{6}$$

$$0.25 < R5g / L < 0.83 \tag{7}$$

where:

L is the distance from the first object to the second object (the overall distance);
f1 is the focal length of the subgroup G-1p of the first lens group;
f2 is the focal length of the subgroup G-2n of the second lens group;
f3 is the focal length of the subgroup G-3p of the third lens group;
f4 is the focal length of the subgroup G-4n of the fourth lens group;
f5p is the focal length of the subgroup G-5p of the fifth lens group;
f5g is the focal length of the subgroup G-5g of the fifth lens group; and
R5g is the radius of curvature of the concave surface on the second object side of the positive lens G-5g of the fifth lens group.

Condition (1) defines an appropriate positive refractive power of the subgroup G-1p which is responsible for providing the primary positive refractive power in the first lens group G1. It is not desirable for a value to exceed the upper limit of the condition (1) because then the negative distortion generated in the second, the fourth, and the fifth lens groups cannot be corrected completely. It is also not desirable for a value to be beyond the lower limit of the equation (1) where it may cause a high-order positive distortion.

Condition (2) defines an appropriate negative refractive power of the subgroup G-2n which is responsible for providing the primary negative refractive power in the second lens group G2. It is also not desirable for the value in condition (2) to exceed the upper limit, because the Petzval sum cannot be corrected satisfactorily, thereby deteriorating image flatness. When the value of condition (2) exceeds the lower limit, a positive distortion caused by the second lens group G2 grows too large. It is difficult to correct this large positive distortion through use of only the first and the third lens groups.

Condition (3) defines an appropriate positive refractive power of the subgroup G-3p which is responsible for providing the primary positive refractive power in the third lens group G3. It is not desirable for the value to exceed the upper limit of the condition (3) because the telephoto ratio of the telephoto system composed of the second lens group G2 and the third lens group G3, increases requiring a longer projection lens system, and generates a small amount of positive distortion in the third lens group G3 which cannot correct the negative distortion generated by the second, the fourth, and the fifth lens groups. It is also not desirable for the value to exceed the lower limit because a high-order spherical aberration is generated, deteriorating imaging performance.

Condition (4) defines an appropriate negative refractive power of the subgroup G-4n which is responsible for providing the primary negative refractive power in the fourth lens group G4. It is not desirable for the value of condition (4) to exceed the upper limit, because in this case, the Petzval sum cannot be corrected sufficiently, deteriorating image flatness. It is also not desirable for the value to exceed the lower limit because high-order spherical aberration may be generated to deteriorate image contrast.

Condition (5) defines an appropriate positive refractive power of the subgroup G-5p which is responsible for the primary positive refractive power in the fifth lens group G5. Now it is not desirable for the value of condition (5) to exceed the upper limit, because in this case, the entire positive refractive power of the fifth lens group becomes too weak. This consequently requires a longer projection lens system. Also, it is not desirable for the value to exceed the lower limit of condition (5), because the levels of negative distortion and negative spherical aberration are amplified, deteriorating the image flatness.

Condition (6) defines an appropriate positive refractive power of the positive lens G-5g arranged closer to the second object side than the subgroup G-5p in the fifth lens group G5. It is not desirable for the value to exceed the upper limit because the refractive power of the positive lens G-5g becomes so weak that the lenses in the fifth lens group G5 closer to the first object side than the positive lens G-5g are imposed a burden of aberration correction. As a result, the image performance is aggravated in terms of spherical aberration or the entire system is required to be longer. When the value exceeds the lower limit of condition (6), the levels of negative distortion and the negative spherical aberration may be amplified, deteriorating the image flatness.

Condition (7) defines an appropriate ratio of the radius of curvature of the concave surface, faced through the second object side of the positive lens G-5g to object-image length (overall length) of the projection lens system. By having the concave surface face the second object side, a negative spherical aberration is minimized for a beam of higher numerical aperture at the second object side of the positive lens G-5g. Now it is not desirable for the value to exceed the upper limit of condition (7) because a high-order negative spherical aberration is generated on the concave surface which prevents obtaining a larger numerical aperture of the projection lens system. In addition, when the value exceeds the lower limit of condition (7), the beam could not be bent efficiently, since the beam diverges excessively at the concave surface, requiring a lens system which is long in the entire length. In this case, the responsibility to correct aberrations is heavily loaded on other positive lenses in the fifth lens group G5, aggravating the levels of spherical aberration.

In the apparatus incorporating the principles of the present invention, it is necessary for the lens group G5 of the fifth lens group to have the first concave surface whose concave surface N1 faces the first object side; it is also necessary that the radius of curvature Rn1 of the concave surface N1 satisfies the following condition (8):

$$0.125 < -Rn1 / L < 0.33 \tag{8}$$

The first concave surface N1 whose concave surface faces the first object side of the fifth lens group G5 is basically responsible for correcting the negative spherical aberration generated by the positive lens of the fifth lens group G5. In condition (8), an appropriate ratio of the radius of curvature of the first concave surface N1 to image-object distance (overall length) is defined. It is not desirable for the value of condition (8) to exceed the upper limit, because in this case, the negative spherical aberration generated by the positive lens cannot be corrected sufficiently. It is also not desirable for the value to exceed the lower limit because high-order spherical aberration may be generated by over correcting spherical aberration.

Also, in the apparatus incorporating the principles of the present invention, it is preferable that the fifth lens group G5 have at least four positive lenses which satisfy the following condition (9):

$$-10 < (r1 + r2) / (r1 - r2) < -0.1 \tag{9}$$

where:

r1 is the radius of curvature on the first object side in at least four positive lenses; and
r2 is the radius of curvature on the second object side in at least four positive lenses.

The above condition (9) defines the shape of the positive lens included in the fifth lens group G5. When the lens is shaped such that the value of condition (9) exceeds its upper limit, a negative spherical aberration grows too large to be corrected; When the lens is shaped such that the value of equation (9) exceeds its lower limit, the negative distortion grows too large to be corrected. The fifth lens group G5 is arranged closer to the second object side than other lens groups such that a beam with higher numerical aperture passes through the lens group. For this reason when there are less than four positive lenses which satisfy the above condition (9) in the fifth lens group G5, it becomes difficult to simultaneously correct both a spherical aberration in a large numerical aperture and a distortion in a wide exposure range.

Also in the apparatus incorporating the principles of the present invention, it is necessary that the fifth lens group G5 has a second concave surface N2 whose concave surface faces the second object side and a third concave surface N3 whose concave surface faces to the second object side and is located closer to the second object side than the second concave surface N2 and these second and third concave surfaces N2 and N3 satisfy the following conditions (10) and (11):

$$0.16 < Rn2 / L < 0.38 \qquad (10)$$

$$0.055 < Rn3 / L < 0.11 \qquad (11)$$

where:

Rn2 is the radius of curvature of the second concave surface N2; and
Rn3 is the radius of curvature of the third concave surface N3.

The second concave surface N2 and the third concave surface N3 whose concave surfaces face the second object side in the fifth lens group G5 have a function for primarily correcting negative spherical distortion and negative distortion by the positive lens in the fifth lens group G5. The above conditions (10) and (11) define an appropriate radius of curvature ratio between the second concave surface N2 to the object-image length (overall length) and the third concave surfaces N3 to the object-image length (overall length).

It is not desirable for the value to exceed the upper limit of conditions (10) and (11) because negative spherical aberration and distortion remains. When the value exceeds the lower limit, spherical aberration increases excessively, causing a high-order spherical aberration, which is especially not desired.

In the apparatus incorporating the principles of the present invention, when the radius of curvature of the positive lens whose surface faces the second object side in the second lens group G2 is Rp1, it is preferable to satisfy the following condition (12):

$$0.23 < -Rp1 / L < 0.5 \qquad (12)$$

Condition (12) defines the radius of curvature of the convex surface facing the second object side of the positive lens in the second lens group G2 with respect to object-image distance (overall distance). This convex surface is responsible for correcting the negative distortion generated in the second, the fourth, and the fifth lens groups G2, G4, and G5, respectively. It is not desirable for the value of condition (12) to exceed the upper limit, because correction of distortion will be insufficient, leaving a residual negative distortion. Also, it is also not desirable for the value of condition (12) to exceed the lower limit, especially because distortion increases excessively, causing a high-order positive distortion.

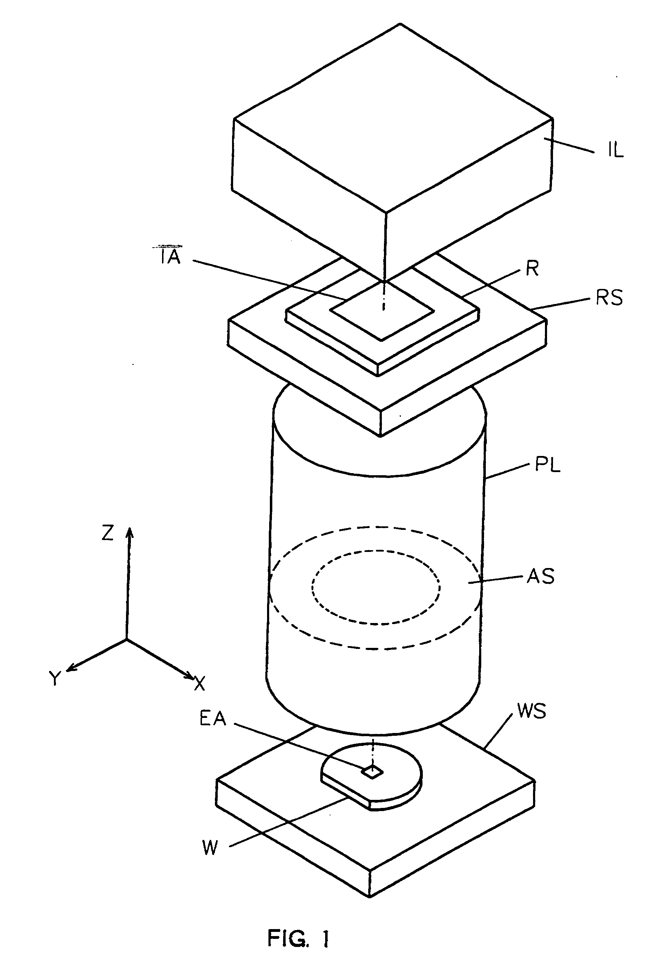

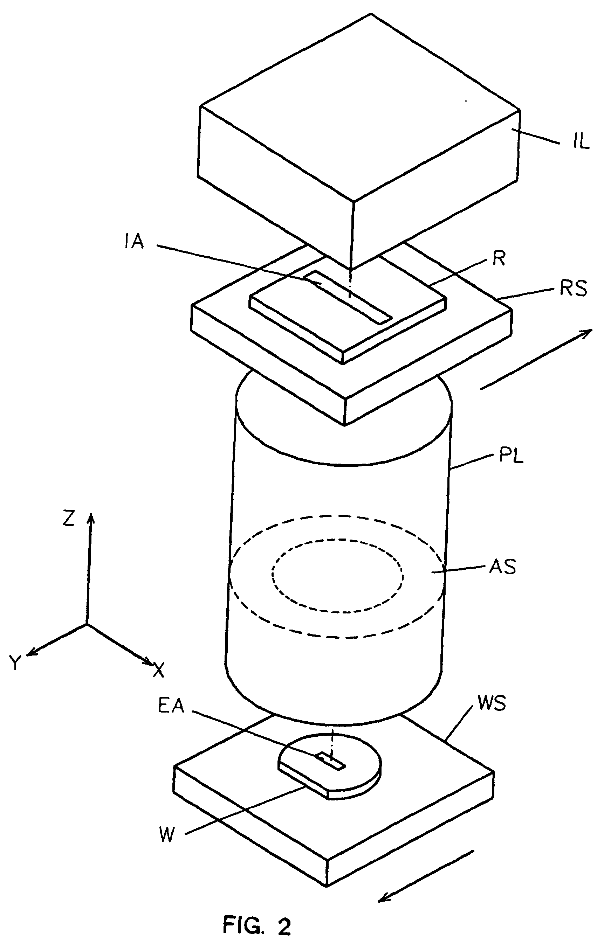

Next, an embodiment of the projection optical system of the present invention applied to a projection exposure system is described referring to the figures. Figure 1 is a perspective view showing an embodiment of the projection optical system of the present invention applied to a step-and-repeat type projection exposure system; Figure 2 is a perspective view showing an embodiment of the projection optical system of the present invention applied to a step-and-scan-type projection exposure system.

Projection exposure apparatus of Figures 1 and 2 are used in an exposing process of forming an IC pattern for integrated circuits and liquid crystal panels, for example.

First, in Figure 1, a reticle R (the first object) as a mask substrate on which a predetermined circuit pattern is drawn, is arranged on the surface of an object of the projection optical system PL. A wafer W (the second object) is arranged on the image surface of the projection optical system PL. The reticle R is held on a reticle stage RS and the wafer W is held on a wafer stage WS. Both stages RS and WS are movable in the XY direction in the figures. Also, above the reticle R (in the Z-direction side,) an illumination optical system IL is arranged for uniformly irradiating the illumination region 1A of a reticle R with exposure light in the ultraviolet band. The illumination optical system IL in this embodiment supplies i-line ($\lambda$ = 365 nm) in the ultraviolet light band.

With the above configuration, exposure light in the ultraviolet band supplied by the illumination optical system IL irradiates the illumination region IA on the reticle R uniformly. The exposure light which passes through the reticle R forms a light source image at an aperture stop AS of the projection optical system PL. That is, the reticle R is illuminated by Koehler's illumination technique using the illumination optical system IL. An image within the illumination region IA of the reticle R is formed on the exposure region EA of the wafer W and the circuit pattern on the reticle R is printed onto the wafer W.

Next, the difference between the embodiment shown in Figure 2 and that of Figure 1 is that in Figure 2 the reticle stage RS holding the reticle R and the wafer stage WS holding the wafer W scan in the opposite directions during the exposure. With this function, the image of the circuit pattern on the reticle R is scan-exposed onto the wafer W.

In the above embodiment shown in Figures 1 and 2, the projection optical system PL is substantially telecentric at the first object side (reticle R side) and the second object side (wafer W side) and has a reduction magnification.

That is, the image formed on the wafer W is smaller in size than the pattern on the reticle R.

As noted above, Figures 1 and 2 are schematic diagrams to explain the projection optical system in the exposure apparatus. These diagrams have been made simple in order to avoid unnecessarily complicating the drawings. For a more complete description of such exposure systems, reference may be made to U.S. Patent Nos. 4,918,583, 5,245,384, 4,497,015, and 5,420,417, assigned to the assignee of the present invention.

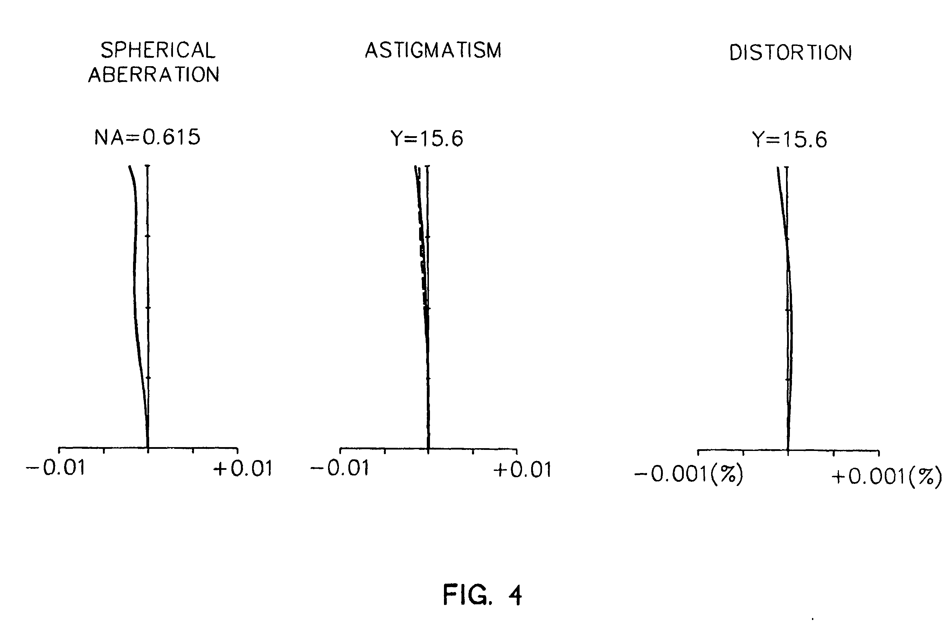

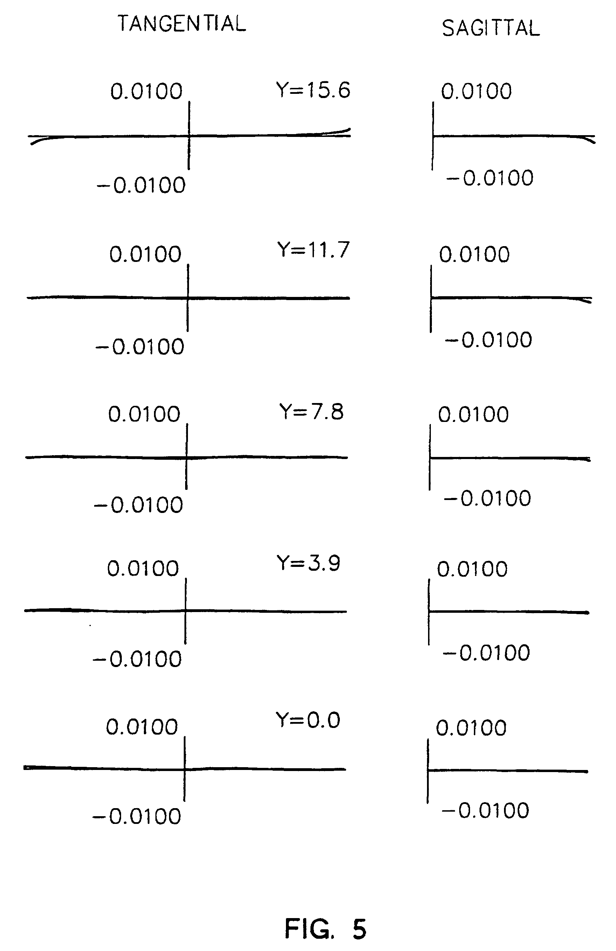

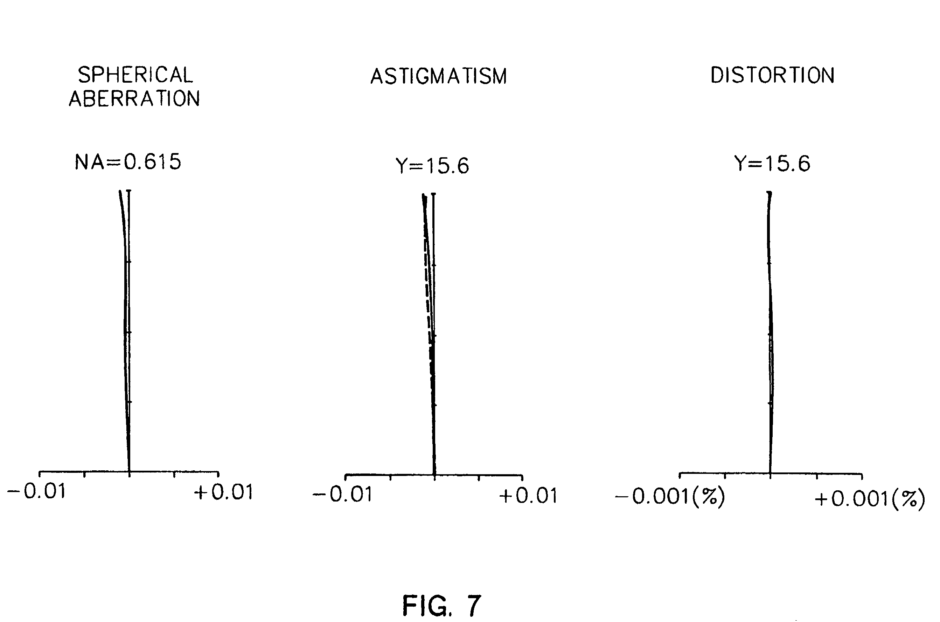

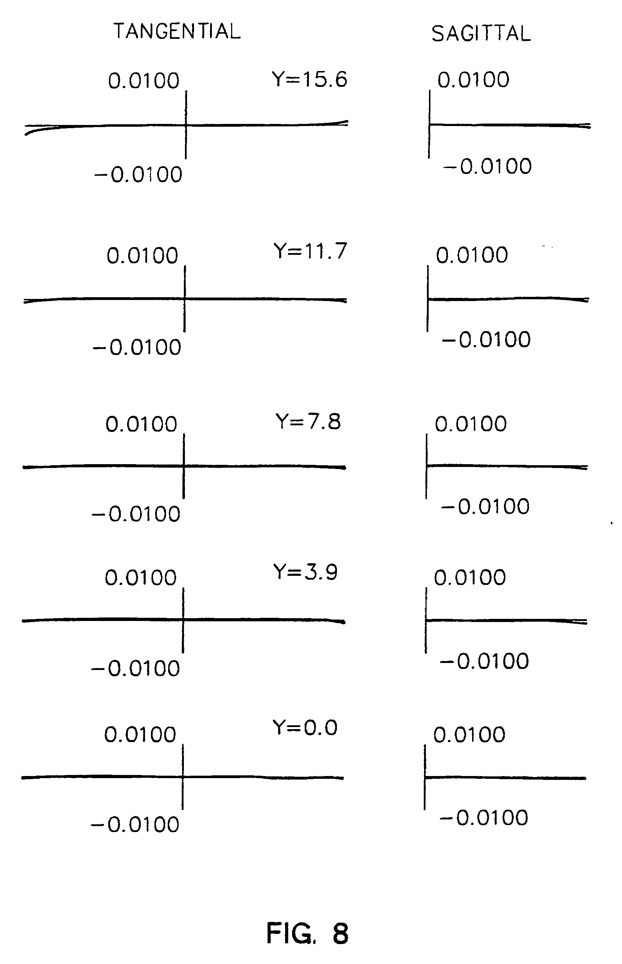

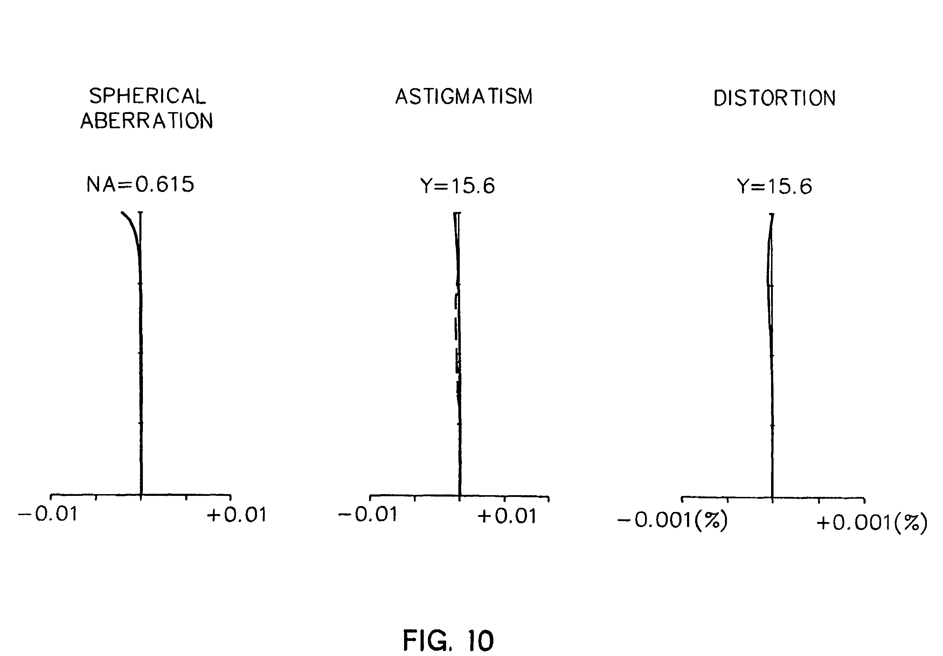

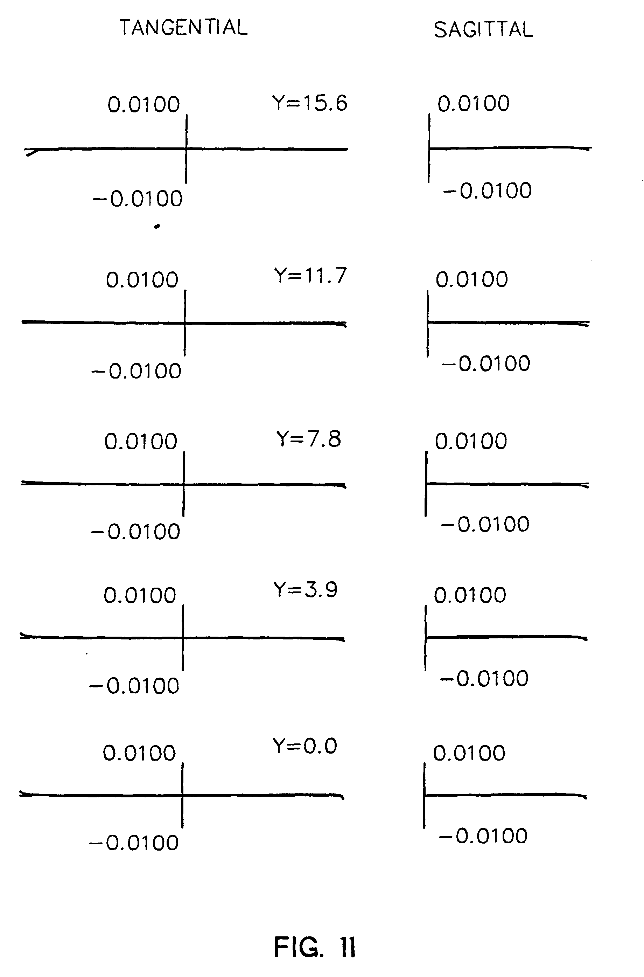

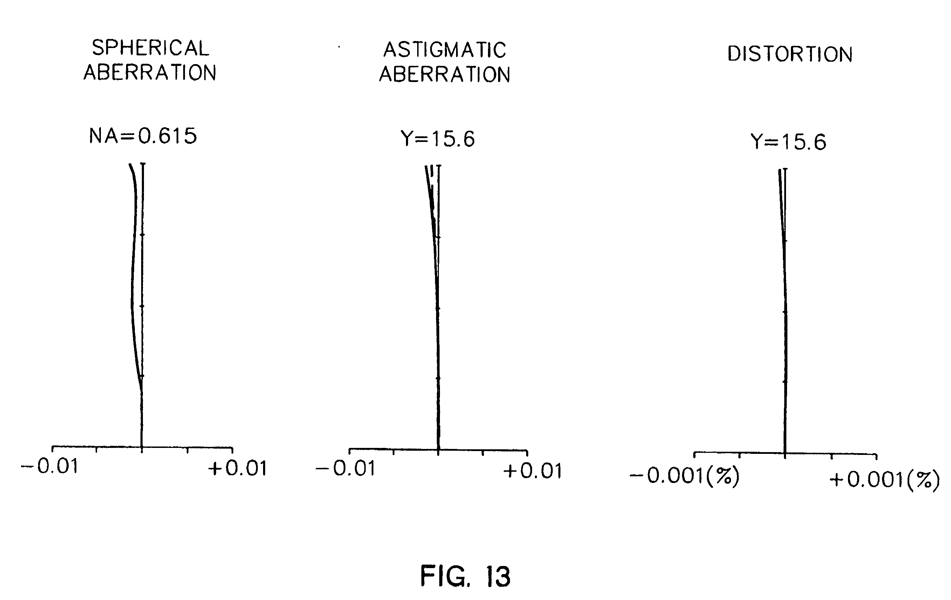

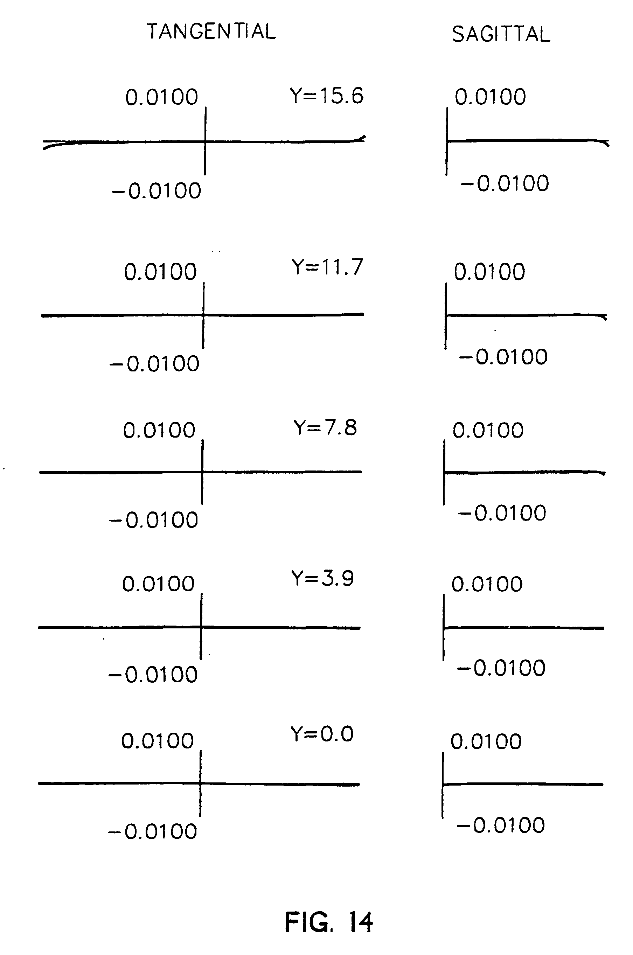

Next, embodiments of the projection optical system incorporating the principles of the present invention are described referring to Figures 3 through 14. Figures 3, 6, 9 and 12 show the cross-section of the lens projection optical system of Embodiments 1 through 3 respectively; Figures 4, 7, 10 and 13 are diagrams showing longitudinal aberrations of the projection optical system of Embodiments 1 through 4 respectively; Figures 5, 8, 11 and 14 show the transverse aberrations (lateral aberrations) of the projection optical system of Embodiments 1 through 4 respectively.

**Embodiment 1**

In Figure 3, the projection optical system of Embodiment 1 comprises, in the order from the first object (reticle R):

a first lens group G1 having a positive refractive power;
a second lens group G2 having a negative refractive power;
a third lens group G3 having a positive refractive power;
a fourth lens group G4 having a negative refractive power; and
a fifth lens group G5 having a positive refractive power.

The first lens group G1 is comprised of, in order from the first object side, a positive biconvex lens L11, a negative biconcave lens L12, two biconvex positive lenses L13 and L14, a plano-convex positive lens L15 whose convex surface faces the first object side, and a plano-concave negative lens L16 whose concave surface faces the second object side. A subgroup G-1p having a positive refractive power in the first lens group G1 is comprised of two biconvex positive lenses L13 and L14.

The second lens group G2 is comprised of, in order from the first object side, a positive biconvex lens L21, a plano-concave negative lens L22 whose concave surface faces the second object side, a negative biconcave lens L23 and a plano-negative concave lens L24 whose concave surface faces the first object side. A subgroup G-2n having a negative refractive power in the second lens group G2 is comprised of three negative lenses L22 through L24.

The third lens group G3 is comprised of, in order from the first object side, a plano-convex positive lens L31 whose convex surface faces the second object side, a meniscus negative lens L32 whose concave surface faces the first object side, a meniscus positive lens L33 whose concave surface faces the first object side, two positive convex lenses L34 and L35, and a meniscus positive lens L36 whose convex surface faces the first object side. A subgroup G-3p having a positive refractive power in the third lens group G3 is comprised of three positive lenses L33 through L35.

The fourth lens group G4 is comprised of, in order from the first object side, a convex meniscus lens L41 whose convex surface faces the first object side, a meniscus negative lens L42 whose convex surface faces the first object side, a biconcave negative lens L43, a meniscus negative lens L44 whose concave surface faces the first object side, and a meniscus positive lens L45 whose convex surface faces the second object side. A subgroup G-4n having negative refractive power in the fourth lens group G4 is comprised of three negative lenses L42 through L44.

The fifth lens group G5 is comprised of, in order from the first object side, a meniscus positive lens L5 1 whose concave surface faces the first object side, a biconvex positive lens L52, a meniscus negative lens L53 whose concave surface N1 faces the first object side, a meniscus negative lens L54 whose concave surface N2 faces the second object side, a biconvex positive lens L55, three meniscus positive lenses L56 through L58 whose convex surface faces the first object side, a meniscus negative lens L59 whose concave surface N3 faces the second object side, and a meniscus positive lens G-5g whose concave surface faces the second object side. A subgroup G-5p in the fifth lens group G5 having a positive refractive power is comprised of positive lenses L51 and L52, negative lenses L53 and L54, and positive lenses L55 through L57.

In the projection optical system of the first embodiment, an aperture stop AS is arranged between the fourth lens group G4 and the fifth lens group G5.

**Embodiment 2**

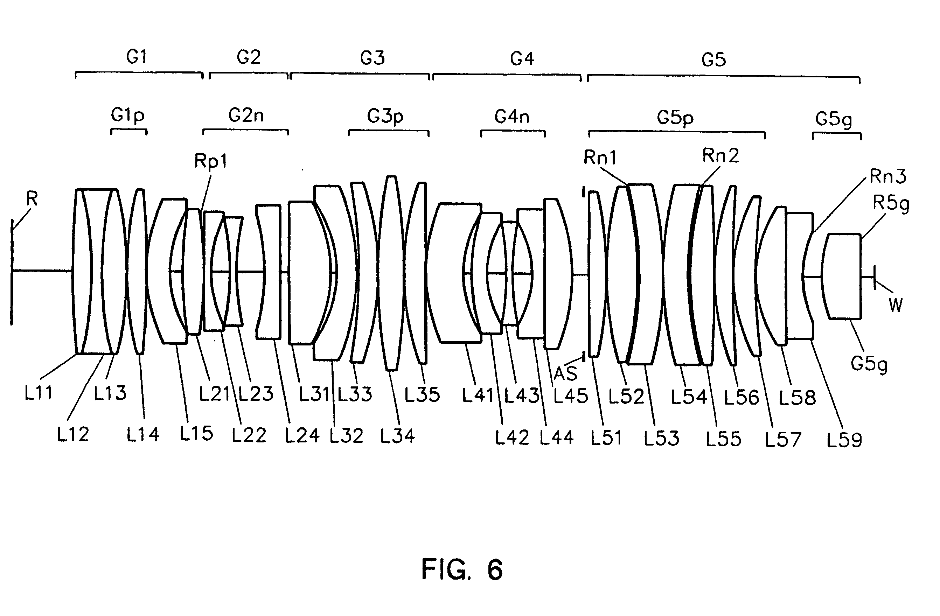

In Figure 6, the projection optical system of Embodiment 2 is comprised of, in order from the first object (reticle R) side, a first lens group G1 having a positive refractive power, a second lens group G2 having a negative refractive power, a third lens group G3 having a positive refractive power, a fourth lens group G4 having a negative refractive power, and a fifth lens group G5 having a positive refractive power.

The first lens group G1 is comprised of, in order from the first object side, a biconvex positive lens L11, a biconcave negative lens L12, two biconvex positive lenses L13 and L14, and a meniscus negative lens L15 whose concave surface faces the second object side. In the first lens group G1, a subgroup G-1p having a positive refractive power in the first lens group G1 is comprised of two positive lenses L13 and L14.

The second lens group G2 is comprised of, in order from the first object side, a biconvex positive lens L21, a plano-concave negative lens L22 whose concave surface faces the second object side, a biconcave negative lens L23 and a plano-concave negative lens L24 whose concave surface faces the first object side. A subgroup G-2n having a negative refractive power in the second lens group G2 is comprised of three negative lenses L22 through L24.

The third lens group G3 is comprised of, in order from the first object side, a meniscus positive lens L31 whose concave surface faces the first object side, a meniscus negative lens L32 whose concave surface faces the first object side, a meniscus positive lens L33 whose concave surface faces the first object side, a biconvex positive lens L34, and a meniscus positive lens L35 whose convex surface faces the first object side. A subgroup G-3p having a positive refractive power in the third lens group G3 is comprised of three positive lenses L33 through L35.

The fourth lens group G4 is comprised of, in order from the first object side, a meniscus positive lens L41 whose convex surface faces the first object side, a meniscus negative lens L42 whose convex surface faces the first object side, a biconcave negative lens L43, a meniscus negative lens L44 whose concave surface faces the first object side, and a meniscus positive lens L45 whose convex surface faces the second object side. A subgroup G-4n having a negative refractive power in the fourth lens group G4 is comprised of three negative lenses L42 through L44.

The fifth lens group G5 is comprised of, in order from the first object side, a meniscus positive lens L51 whose concave surface faces the first object side, a biconvex positive lens L52, a meniscus negative lens L53 whose concave surface N1 faces the first object side, a meniscus negative lens L54 whose concave surface N2 faces the second object side, a biconvex positive lens L55, and three meniscus positive lenses L56 through L58 whose convex surface faces the first object side, a meniscus negative lens L59 whose concave surface N3 faces the second object side, and a meniscus positive lens G-5g whose concave surface faces the second object side. A subgroup G-5p in the fifth lens group having a positive refractive power is constructed with positive lenses L51 and L52, negative lenses L53 and L54, and positive lenses L55 through L57.

In the projection optical system of Embodiment 2, an aperture stop AS is arranged between the fourth lens group G4 and the fifth lens group G5.

## Embodiment 3

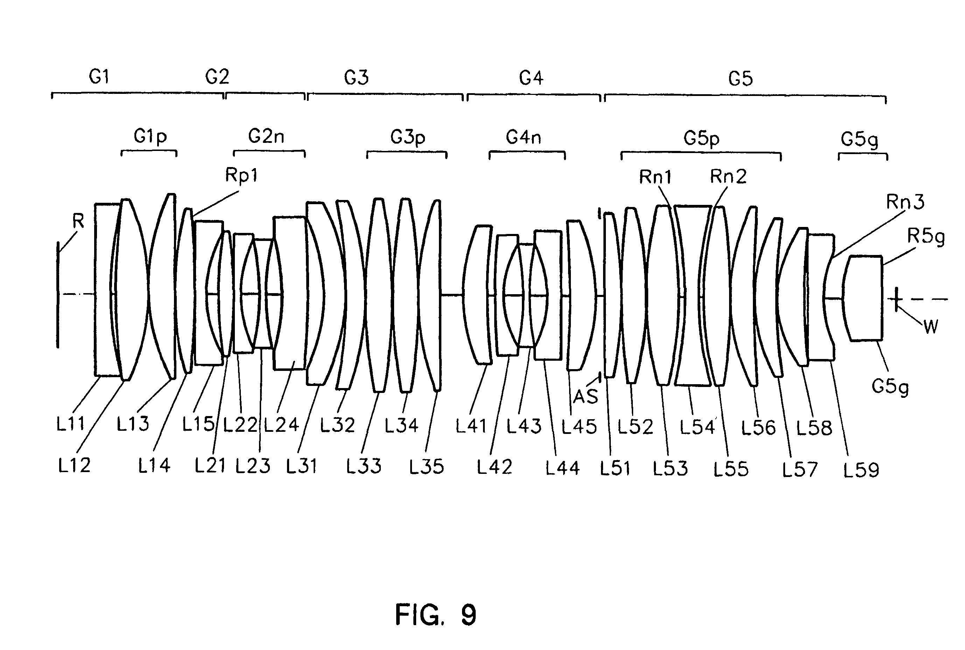

In Figure 9, the projection optical system of Embodiment 3 is comprised of, in order from the first object (reticle R), a first lens group G1 having a positive refractive power, a second lens group G2 having a negative refractive power, a third lens group G3 having a positive refractive power, a fourth lens group G4 having a negative refractive power, and a fifth lens group G5 having a positive refractive power.

The first lens group G 1 of Embodiment 3 is comprised of, in order from the first object side, a meniscus negative lens L11 whose convex surface faces the first object side, three biconvex positive lenses L12 through L14, and a plano-concave negative lens L15 whose concave surface faces the second object side. A subgroup G-1p having a positive refractive power in the first lens group G1 is comprised of two positive lenses L12 and L13.

The second lens group G2 is comprised of, in order from the first object side, a biconvex positive lens L21, a plano-concave negative lens L22 whose concave surface faces the second object side, a biconcave negative lens L23, and a meniscus negative lens L24 whose concave surface faces the first object side. A subgroup G-2n having a negative refractive power is comprised of the three negative lenses L22 through L24.

The third lens group G3 is comprised of, in order from the first object side, two meniscus positive lenses L31 and L32 and three biconvex positive lenses L33 through L35. A subgroup G-3p having a positive refractive power is constructed with the three positive lenses L33 through L35.

The fourth lens group G4 is comprised of, in order from the first object side, a meniscus positive lens L41 whose convex surface faces the first object side, a meniscus negative lens L42 whose convex surface faces the first object side, a biconcave negative lens L43, a plano-concave negative lens L44 whose concave surface faces the first object side, and a meniscus positive lens L45 whose convex surface faces the second object side. A subgroup G-4n having a negative refractive power in the fourth lens group G4 is comprised of three negative lenses L42 through L44.

The fifth lens group G5 is comprised of, in order from the first object side, a meniscus positive lens L51 whose concave surface faces the first object side, two biconvex positive lenses L52 and L53, a biconcave negative lens L54 having both a concave surface N1 which faces the first object side and a concave surface N2 whose surface faces the second object side, a biconvex positive lens L55, three meniscus positive lenses L56 through L58 whose convex surface faces the first object side, a meniscus negative lens L59 whose concave surface N3 faces the second object side, and a meniscus positive lens G-5g whose concave surface faces the second object side. A subgroup G-5p having a positive refractive power in the fifth lens group G5 is constructed with positive lenses L51 through L53, negative lens L54, and positive lenses L55 through L57.

Note that in the projection optical system of Embodiment 3, an aperture stop AS is arranged between the fourth lens group G4 and the fifth lens group G5.

**Embodiment 4**

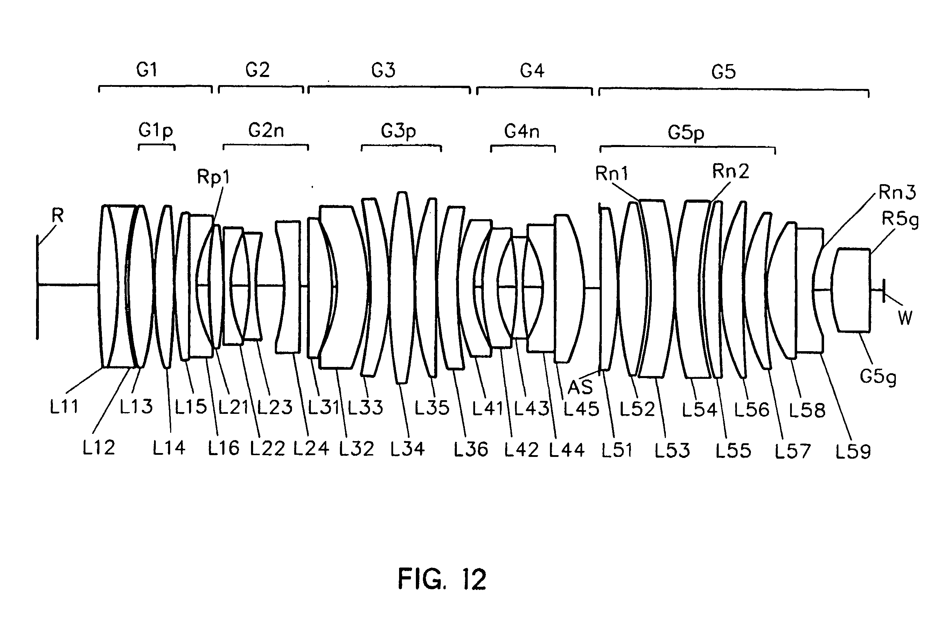

In Fig. 12, the projection optical lens system of Embodiment 4 is comprised of, in order from the first object (reticle R) side, a first lens group G1 having a positive refractive power, a second lens group G2 having a negative refractive power, a third lens group G3 having a positive refractive power, a fourth lens group G4 having a negative power, and a fifth lens group G5 having a positive refractive power.

The first lens group G1 is comprised of, in order from the first object side, a biconvex positive lens L11, biconcave negative lens L12, two biconvex positive lenses L13 and L14, a plano-convex positive lens L15 whose convex surface faces the first object side, and a plano-concave negative lens L16 whose concave surface faces the second object side. In the first lens group G1, a sub-group G1p having a positive refractive power is constructed with two biconvex positive lenses L13 and L14.

The second lens group G2 is comprised of, in order from the first object side, a biconvex positive lens L21, a plano-concave negative lens L22 whose concave surface faces the second object side, a biconcave negative lens L23, and a plano-concave negative lens L24 whose concave surface faces the first object side. In the second lens group G2, a sub-group G2n having a negative refractive power is constructed with three negative lenses L22 through L24.

The third lens group G3 is comprised of, in order from the first object side, a convex positive lens L31 whose convex surface faces the second object side, a meniscus negative lens L32 whose concave surface faces the first object side, a meniscus positive lens L33 whose concave surface faces the first object side, two biconvex positive lenses L34 and L35, and a meniscus positive lens L36 whose convex surface faces the first object side. In the third lens group G3, a sub-group G3p having a positive refractive power is constructed with three positive lenses L33 through L35.

The fourth lens group G4 is comprised of, in order from the first object side, a meniscus positive lens L41 whose convex surface faces the first object side, a meniscus negative meniscus lens L42 whose convex surface faces the first object side, a biconcave negative lens L43, a meniscus negative lens L44 whose concave surface faces the first object side, and a meniscus positive lens L45 whose convex surface faces the second object side. In the fourth lens group G4, a sub-group G4n having a negative refractive power is constructed with three negative lenses L42 through L44.

The fifth lens group G5 is comprised of, in order from the first object side, a meniscus positive lens L51 whose concave surface faces the first object side, a biconvex positive lenses L52, a meniscus negative lens L53 whose concave surface N1 faces the first object side, a meniscus negative lens L54 whose concave surface N2 faces the second object side, a biconvex positive lens L55, three meniscus positive lenses L56 through L58 whose convex surfaces face the first object side, a meniscus negative lens L59 whose concave surface N3 faces the second object side, and a meniscus positive lens G5g whose concave surface faces the second object side. In the fifth lens group G5, a subgroup G5p having a positive refractive power is constructed with positive lenses L51 and L52, negative lenses L53 and L54, and positive lenses L55 through L57.

Note that in the projection optical system of Embodiment 4, an aperture stop AS is arranged between the fourth lens group G4 and the fifth lens group G5.

Various values and parameters which correspond to various conditions are shown in the following Tables 1 through 6.

In each table, the numbers in the left-hand column denote the order from the first object side (reticle R side); r, the radius of curvature of the lens surface; d, lens surface separation length; n, a refractive index at 365 nm; d0, the lens separation distance between the lens surface (the first lens surface) of the first lens group G1 closest to the first object side (reticle R side); WD, the distance between the surface of a lens of the fifth lens group G5 which is closest to the second object side (wafer W side) and the second object surface (wafer W surface); β, the (lateral) magnification of the projection optical system; NA, the numerical aperture of the projection optical system on the second object side; φEX is the radius of the exposure region on the second object surface (the surface of the plate P); L is an object-image distance (overall distance), the distance (between the first object (reticle R) and the second object (wafer W)); f1, the focal length of the subgroup G-1p in the first lens group G1; f2, the focal length of the subgroup G-2n of the second lens group G2; f3, the focal length of the subgroup G-3p in the third lens group G3; f4, the focal length of the subgroup G-4n of the fourth lens group G4; and f5p is the focal length of the subgroup G-5p in the fifth lens group G5. In each of the tables, f5g is the focal length of the positive lens G-5g in the fifth lens group G5; R5g is the radius of curvature of the concave surface of the positive lens G-5g in the fifth lens group G5 on the second object side (wafer W side); Rn1 is the radius of curvature of the first concave surface N1 whose concave surface faces the first object side (reticle R side) of the fifth lens group G5; Rn2 is the radius of curvature of the second concave surface N2 whose concave surface faces the second object side (wafer W side) in the fifth lens group G5; Rn3 is the radius of curvature of the third concave surface N3 whose concave surface faces the second object side (wafer W side) in the fifth lens group G5, being arranged on the second object side of the second concave surface N2; Rp1 is the radius of curvature of the positive lens whose surface faces the second object side (wafer W side) in the second lens group G2.

Table 1

| Embodiment 1 | | | | |
|---|---|---|---|---|
| d0 = 85.84542 | | | | |
| β = -1/5 | | | | |
| NA = 0.615 | | | | |
| WD = 19.00000 | | | | |
| φ EX = 15.6 | | | | |
| L = 1200.0 | | | | |
| | r | d | n | |
| 1 | +688.21752 | 28.00000 | 1.615481 | |
| 2 | -304.80855 | 3.00000 | 1.000000 | |
| 3 | -260.00000 | 16.00000 | 1.612652 | |
| 4 | +368.80413 | 3.35615 | 1.000000 | |
| 5 | +461.11900 | 29.70000 | 1.488581 | |
| 6 | -307.69507 | 0.50000 | 1.000000 | |
| 7 | +239.65577 | 29.50000 | 1.615481 | |
| 8 | -1376.88881 | 0.50000 | 1.000000 | |
| 9 | +228.88522 | 27.50000 | 1.615481 | |
| 10 | ∞ | 1.00000 | 1.000000 | |
| 11 | ∞ | 16.78114 | 1.612652 | |
| 12 | +111.01247 | 15.18344 | 1.000000 | |
| 13 | +265.68330 | 25.31033 | 1.612652 | |
| 14 | -454.57241 | 0.50000 | 1.000000 | (Rp1) |
| 15 | ∞ | 14.00000 | 1.615481 | |
| 16 | +118.40199 | 22.46541 | 1.000000 | |
| 17 | -226.66098 | 12.50000 | 1.488581 | |
| 18 | + 194.30010 | 41.51491 | 1.000000 | |
| 19 | -156.23447 | 25.10411 | 1.615481 | |
| 20 | ∞ | 13.02696 | 1.000000 | |
| 21 | +34928.96053 | 32.95326 | 1.615481 | |
| 22 | -178.06192 | 10.06888 | 1.000000 | |
| 23 | -131.67222 | 37.89036 | 1.615481 | |
| 24 | -191.14704 | 0.33328 | 1.000000 | |
| 25 | -469.70082 | 24.50000 | 1.615481 | |
| 26 | -283.99212 | 0.50000 | 1.000000 | |
| 27 | +600.00000 | 27.20000 | 1.615481 | |
| 28 | -765.79841 | 1.00000 | 1.000000 | |
| 29 | +355.41259 | 26.70000 | 1.615481 | |
| 30 | -3341.54309 | 0.50000 | 1.000000 | |
| 31 | +282.87225 | 27.76907 | 1.615481 | |
| 32 | +446.45715 | 0.50000 | 1.000000 | |
| 33 | +202.70054 | 32.51731 | 1.615481 | |
| 34 | +200.68509 | 8.59820 | 1.000000 | |
| 35 | +343.84296 | 16.00000 | 1.612652 | |

Table 1   (continued)

| Embodiment 1 | | | | |
|---|---|---|---|---|
| | r | d | n | |
| 36 | +122.88028 | 32.68047 | 1.000000 | |
| 37 | -238.49136 | 12.00000 | 1.615481 | |
| 38 | +327.42830 | 28.94742 | 1.000000 | |
| 39 | -128.99436 | 25.18701 | 1.612652 | |
| 40 | -4297.59062 | 0.74569 | 1.000000 | |
| 41 | -3796.93992 | 35.83378 | 1.488581 | |
| 42 | -182.01599 | 7.50000 | 1.000000 | |
| 43 | ∞ | 10.00000 | 1.000000 | (AS) |
| 44 | -1584.12678 | 24.00000 | 1.488581 | |
| 45 | -259.53358 | 0.52257 | 1.000000 | |
| 46 | +496.66960 | 41.53348 | 1.615481 | |
| 47 | -312.30796 | 5.38895 | 1.000000 | |
| 48 | -259.40216 | 22.50000 | 1.612652 | (Rn1) |
| 49 | -546.90264 | 0.50000 | 1.000000 | |
| 50 | +419.50404 | 22.80000 | 1.612652 | |
| 51 | +260.51140 | 4.26113 | 1.000000 | (Rn2) |
| 52 | +290.00312 | 37.01218 | 1.488581 | |
| 53 | -1172.29742 | 0.50000 | 1.000000 | |
| 54 | +224.50188 | 28.30000 | 1.488581 | |
| 55 | +772.01014 | 0.50000 | 1.000000 | |
| 56 | +160.97601 | 28.20000 | 1.488581 | |
| 57 | +316.67288 | 0.50000 | 1.000000 | |
| 58 | +142.78331 | 42.24908 | 1.488581 | |
| 59 | +1374.88582 | 0.80000 | 1.000000 | |
| 60 | + 1400.00000 | 21.59241 | 1.612652 | |
| 61 | +80.50236 | 23.59041 | 1.000000 | (Rn3) |
| 62 | +86.82687 | 65.03716 | 1.612652 | |
| 63 | +723.24389 | (WD) | 1.000000 | (R5g) |

Table 2

| Conditions Corresponding to Values of Embodiment 1 | | |
|---|---|---|
| (1) | f1 / L = 0.151 | |
| (2) | -f2 / L = 0.049 | |
| (3) | f3 / L = 0.181 | |
| (4) | -f4 / L = 0.058 | |
| (5) | f5p / L = 0.125 | |
| (6) | f5g / L = 0.129 | |
| (7) | R5g / L = 0.603 | |
| (8) | -Rn1 / L = 0.216 | |
| (9) | (r1 + r2) / (r1 - r2) = -0.603 (L55) | |
| | (r1 + r2) / (r1 - r2) = -1.820 (L56) | |
| | (r1 + r2) / (r1 - r2) = -3.067 (L57) | |
| | (r1 + r2) / (r1 - r2) = -1.232 (L58) | |
| | (r1 + r2) / (r1 - r2) = -1.273 (G-5g) | |
| (10) | Rn2 / L = 0.217 | |
| (11) | Rn3 / L = 0.067 | |

Table 2   (continued)

| Conditions Corresponding to Values of Embodiment 1 | |
|---|---|
| (12) | -Rp1 / L = 0.379 |

Table 3

| Embodiment 2 | | | | |
|---|---|---|---|---|
| d0 = 80.999999 | | | | |
| β = -1/5 | | | | |
| NA = 0.615 | | | | |
| WD = 18.500000 | | | | |
| φ EX = 15.6 | | | | |
| L = 1206.0 | | | | |
| | r | d | n | |
| 1 | +750.16279 | 31.500000 | 1.615481 | |
| 2 | -220.00000 | 1.000000 | 1.000000 | |
| 3 | -218.06788 | 15.000000 | 1.612652 | |
| 4 | +325.97570 | 5.500000 | 1.000000 | |
| 5 | +491.19195 | 29.000000 | 1.488581 | |
| 6 | -347.17405 | 0.500000 | 1.000000 | |
| 7 | +209.56408 | 29.000000 | 1.615481 | |
| 8 | -2963.85079 | 0.100000 | 1.000000 | |
| 9 | +240.78134 | 32.643740 | 1.612652 | |
| 10 | +117.46219 | 14.500000 | 1.000000 | |
| 11 | +244.32765 | 34.452790 | 1.615481 | |
| 12 | -460.28921 | 0.500000 | 1.000000 | (Rp1) |
| 13 | ∞ | 14.000000 | 1.488581 | |
| 14 | +111.22015 | 22.500000 | 1.000000 | |
| 15 | -345.82103 | 11.000000 | 1.488581 | |
| 16 | +166.18604 | 40.292246 | 1.000000 | |
| 17 | -139.60880 | 19.485492 | 1.615481 | |
| 18 | ∞ | 11.087291 | 1.000000 | |
| 19 | -687.60891 | 50.004491 | 1.615481 | |
| 20 | -179.90164 | 13.955924 | 1.000000 | |
| 21 | -133.90676 | 30.456495 | 1.615481 | |
| 22 | -169.00248 | 0.211350 | 1.000000 | |
| 23 | -768.89404 | 24.230173 | 1.615481 | |
| 24 | -367.90453 | 0.697066 | 1.000000 | |
| 25 | +589.13165 | 28.000000 | 1.615481 | |
| 26 | -665.24739 | 1.000000 | 1.000000 | |
| 27 | +294.16305 | 27.500000 | 1.615481 | |
| 28 | -8769.55173 | 5.000000 | 1.000000 | |
| 29 | +253.91512 | 62.624436 | 1.615481 | |
| 30 | +263.05747 | 5.500000 | 1.000000 | |
| 31 | +376.43451 | 16.000000 | 1.612652 | |
| 32 | +127.23648 | 31.365482 | 1.000000 | |
| 33 | -239.44157 | 18.177545 | 1.615481 | |
| 34 | +377.83226 | 25.803559 | 1.000000 | |
| 35 | -128.22564 | 24.700973 | 1.612652 | |

Table 3   (continued)

| | | r | d | n | |
|---|---|---|---|---|---|
| | | | **Embodiment 2** | | |
| | | r | d | n | |
| 36 | | -4833.52939 | 1.375434 | 1.000000 | |
| 37 | | -4745.08654 | 38.000000 | 1.488581 | |
| 38 | | -185.32072 | 4.501154 | 1.000000 | |
| 39 | | ∞ | 10.000000 | 1.000000 | (AS) |
| 40 | | -1309.89752 | 22.500000 | 1.488581 | |
| 41 | | -258.91713 | 0.500000 | 1.000000 | |
| 42 | | +494.92084 | 36.200000 | 1.615481 | |
| 43 | | -358.82852 | 7.000000 | 1.000000 | |
| 44 | | -257.60152 | 22.500000 | 1.612652 | (Rn1) |
| 45 | | -419.07467 | 0.500000 | 1.000000 | |
| 46 | | +505.02516 | 22.500000 | 1.612652 | |
| 47 | | +272.40529 | 4.500000 | 1.000000 | (Rn2) |
| 48 | | +317.61979 | 35.000000 | 1.488581 | |
| 49 | | -792.89840 | 0.500000 | 1.000000 | |
| 50 | | +218.71786 | 28.962888 | 1.488581 | |
| 51 | | +662.60545 | 0.500000 | 1.000000 | |
| 52 | | +161.06828 | 28.860652 | 1.488581 | |
| 53 | | +349.22176 | 0.500000 | 1.000000 | |
| 54 | | +140.52530 | 40.500000 | 1.488581 | |
| 55 | | +1115.07674 | 1.200000 | 1.000000 | |
| 56 | | +1121.39823 | 27.157998 | 1.612652 | |
| 57 | | +78.14303 | 25.119961 | 1.000000 | (Rn3) |
| 58 | | +83.95729 | 61.871165 | 1.615481 | |
| 59 | | +610.60171 | (WD) | 1.000000 | (R5g) |

Table 4

| | Conditions Corresponding to Values of Embodiment 2 | |
|---|---|---|
| (1) | f1 / L = 0.153 | |
| (2) | -f2 / L = 0.052 | |
| (3) | f3 / L = 0.167 | |
| (4) | -f4 / L = 0.059 | |
| (5) | f5p / L = 0.123 | |
| (6) | f5g / L = 0.126 | |
| (7) | R5g / L = 0.506 | |
| (8) | -Rn1 / L = 0.214 | |
| (9) | (r1 + r2) / (r1 - r2) = -0.428 (L55) | |
| | (r1 + r2) / (r1 - r2) = -1.985 (L56) | |
| | (r1 + r2) / (r1 - r2) = -2.712 (L57) | |
| | (r1 + r2) / (r1 - r2) = -1.288 (L58) | |
| | (r1 + r2) / (r1 - r2) = -1.319 (G-5g) | |
| (10) | Rn2 / L = 0.226 | |
| (11) | Rn3 / L = 0.065 | |
| (12) | -Rp1 / L = 0.382 | |

Table 5

| | | | |
|---|---|---|---|
| **Embodiment 3** | | | |
| d0 = 89.000005 | | | |
| β = -1/5 | | | |
| NA = 0.615 | | | |
| WD = 24.111595 | | | |
| φ EX = 15.6 | | | |
| L = 1196.9 | | | |

| | r | d | n | |
|---|---|---|---|---|
| 1 | +1939.55307 | 20.000000 | 1.612652 | |
| 2 | +281.11390 | 10.000000 | 1.000000 | |
| 3 | +449.55943 | 35.270328 | 1.488581 | |
| 4 | -297.94975 | 0.750000 | 1.000000 | |
| 5 | +218.50353 | 33.087008 | 1.615481 | |
| 6 | -14376.50699 | 0.750000 | 1.000000 | |
| 7 | +244.41294 | 29.787159 | 1.615481 | |
| 8 | -1864.37795 | 2.687228 | 1.000000 | |
| 9 | ∞ | 18.000000 | 1.612652 | |
| 10 | +118.07733 | 18.830325 | 1.000000 | |
| 11 | +279.00240 | 27.626374 | 1.488581 | |
| 12 | -286.15373 | 0.750000 | 1.000000 | (Rp1) |
| 13 | ∞ | 15.000000 | 1.615481 | |
| 14 | +121.77422 | 29.691393 | 1.000000 | |
| 15 | -167.29133 | 15.000000 | 1.488581 | |
| 16 | +221.37517 | 28.176548 | 1.000000 | |
| 17 | -138.14211 | 22.698390 | 1.615481 | |
| 18 | -694.99352 | 17.324597 | 1.000000 | |
| 19 | -185.35363 | 22.000000 | 1.615481 | |
| 20 | -163.34223 | 0.750000 | 1.000000 | |
| 21 | -345.59298 | 23.000000 | 1.615481 | |
| 22 | -212.88125 | 0.750000 | 1.000000 | |
| 23 | +837.47091 | 26.807371 | 1.615481 | |
| 24 | -592.54078 | 0.750000 | 1.000000 | |
| 25 | +459.67736 | 31.017354 | 1.615481 | |
| 26 | -907.11817 | 0.750000 | 1.000000 | |
| 27 | +350.77664 | 29.961953 | 1.615481 | |
| 28 | -2426.68761 | 34.608122 | 1.000000 | |
| 29 | +306.42564 | 31.336383 | 1.615481 | |
| 30 | +852.58779 | 9.336240 | 1.000000 | |
| 31 | + 1574.58744 | 15.000000 | 1.612652 | |
| 32 | + 153.47868 | 32.327949 | 1.000000 | |
| 33 | -218.70659 | 15.000000 | 1.474577 | |
| 34 | +223.84681 | 32.858042 | 1.000000 | |
| 35 | -130.06518 | 34.891416 | 1.612652 | |
| 36 | ∞ | 11.977743 | 1.000000 | |
| 37 | -875.00063 | 29.234902 | 1.488581 | |
| 38 | -197.32427 | 5.753854 | 1.000000 | |
| 39 | ∞ | 5.750000 | 1.000000 | (AS) |
| 40 | +10711.4496 | 24.726209 | 1.488581 | |

Table 5   (continued)

| | r | d | n | |
|---|---|---|---|---|
| | | **Embodiment 3** | | |
| 41 | -362.20077 | 0.750000 | 1.000000 | |
| 42 | +1119.16124 | 29.083421 | 1.615481 | |
| 43 | -446.03300 | 0.750000 | 1.000000 | |
| 44 | +406.10622 | 36.912931 | 1.615481 | |
| 45 | -582.51787 | 10.094086 | 1.000000 | |
| 46 | -343.68000 | 25.000000 | 1.612652 | (Rn1) |
| 47 | +405.99622 | 3.000000 | 1.000000 | (Rn2) |
| 48 | +419.51179 | 30.258707 | 1.488581 | |
| 49 | -821.25172 | 0.750000 | 1.000000 | |
| 50 | +290.40653 | 31.872997 | 1.488581 | |
| 51 | +5465.29011 | 0.750000 | 1.000000 | |
| 52 | +193.15728 | 31.609321 | 1.488581 | |
| 53 | +704.11950 | 0.750000 | 1.000000 | |
| 54 | +123.03501 | 37.520745 | 1.488581 | |
| 55 | +456.16128 | 6.394985 | 1.000000 | |
| 56 | +615.85448 | 24.530116 | 1.612652 | |
| 57 | +75.77168 | 19.182042 | 1.000000 | (Rn3) |
| 58 | +81.95198 | 50.514912 | 1.615481 | |
| 59 | +798.82187 | (WD) | 1.000000 | (R5g) |

Table 6

| | Conditions Corresponding to Values of Embodiment 3 |
|---|---|
| (1) | $f_1 / L = 0.153$ |
| (2) | $-f_2 / L = 0.051$ |
| (3) | $f_3 / L = 0.157$ |
| (4) | $-f_4 / L = 0.054$ |
| (5) | $f_{5p} / L = 0.151$ |
| (6) | $f_{5g} / L = 0.121$ |
| (7) | $R_{5g} / L = 0.667$ |
| (8) | $-R_{n1} / L = 0.287$ |
| (9) | $(r_1 + r_2) / (r_1 - r_2) = -0.323$ (L55) |
| | $(r_1 + r_2) / (r_1 - r_2) = -1.112$ (L56) |
| | $(r_1 + r_2) / (r_1 - r_2) = -1.756$ (L57) |
| | $(r_1 + r_2) / (r_1 - r_2) = -1.739$ (L58) |
| | $(r_1 + r_2) / (r_1 - r_2) = -1.228$ (G-5g) |
| (10) | $R_{n2} / L = 0.339$ |
| (11) | $R_{n3} / L = 0.063$ |
| (12) | $-R_{p1} / L = 0.239$ |

Table 7

| **Embodiment 4** |
|---|
| $d_0 = 81.01932$ |
| $\beta = -1/5$ |
| NA = 0.63 |

Table 7   (continued)

| | | r | d | n | |
|---|---|---|---|---|---|
| **Embodiment 4** | | | | | |
| WD = 19.94252 | | | | | |
| φEX = 15.6 | | | | | |
| L = 1200 | | | | | |
| | 1 | +572.19707 | 26.40000 | 1.488581 | |
| | 2 | -517.13581 | 1.00000 | 1.000000 | |
| | 3 | -576.11938 | 16.00000 | 1.612652 | |
| | 4 | +319.72892 | 4.82984 | 1.000000 | |
| | 5 | +427.45496 | 30.50000 | 1.488581 | |
| | 6 | -348.64320 | 0.50000 | 1.000000 | |
| | 7 | +211.54187 | 29.80000 | 1.615481 | |
| | 8 | -1941.96326 | 0.50000 | 1.000000 | |
| | 9 | +232.39566 | 27.50000 | 1.615481 | |
| | 10 | ∞ | 1.00000 | 1.000000 | |
| | 11 | ∞ | 19.61130 | 1.612652 | |
| | 12 | +108.28670 | 16.93605 | 1.000000 | |
| | 13 | +310.86505 | 24.48600 | 1.612652 | |
| | 14 | -413.92152 | 0.50000 | 1.000000 | (Rp1) |
| | 15 | ∞ | 14.00000 | 1.612652 | |
| | 16 | +115.98913 | 22.76912 | 1.000000 | |
| | 17 | -242.83640 | 12.50000 | 1.612652 | |
| | 18 | +203.84520 | 42.27431 | 1.000000 | |
| | 19 | -158.64281 | 13.26131 | 1.488581 | |
| | 20 | ∞ | 13.26131 | 1.000000 | |
| | 21 | + 5263.42400 | 33.62118 | 1.615481 | |
| | 22 | -182.40419 | 13.08969 | 1.000000 | |
| | 23 | -132.22030 | 37.99541 | 1.615481 | |
| | 24 | -198.71889 | 3.01709 | 1.000000 | |
| | 25 | -504.28103 | 24.50000 | 1.615481 | |
| | 26 | -271.06241 | 0.50000 | 1.000000 | |
| | 27 | +600.00000 | 27.20000 | 1.615481 | |
| | 28 | -728.23893 | 0.50000 | 1.000000 | |
| | 29 | +419.04064 | 26.70000 | 1.615481 | |
| | 30 | -1643.86644 | 0.50000 | 1.000000 | |
| | 31 | +295.50686 | 28.41946 | 1.615481 | |
| | 32 | +520.71040 | 0.50000 | 1.000000 | |
| | 33 | +214.07728 | 32.77156 | 1.615481 | |
| | 34 | +255.89539 | 9.25471 | 1.000000 | |
| | 35 | +637.66197 | 16.00000 | 1.612652 | |
| | 36 | + 132.66792 | 30.54047 | 1.000000 | |
| | 37 | -261.10317 | 12.00000 | 1.615481 | |
| | 38 | +278.54372 | 30.19397 | 1.000000 | |
| | 39 | -129.90564 | 25.13618 | 1.612652 | |
| | 40 | -6068.89035 | 0.78038 | 1.000000 | |
| | 41 | -4001.34463 | 35.75687 | 1.488581 | |
| | 42 | -182.47255 | 11.61871 | 1.000000 | |
| | 43 | ∞ | 5.00000 | 1.000000 | (AS) |
| | 44 | -1901.93658 | 24.00000 | 1.488581 | |

Table 7   (continued)

| | r | d | n | |
|---|---|---|---|---|
| **Embodiment 4** | | | | |
| 45 | -268.92809 | 0.52257 | 1.000000 | |
| 46 | +471.20841 | 40.17914 | 1.615481 | |
| 47 | -328.64737 | 5.49342 | 1.000000 | |
| 48 | -264.96403 | 22.50000 | 1.612652 | (Rn1) |
| 49 | -559.53762 | 0.50000 | 1.000000 | |
| 50 | +431.81643 | 22.80000 | 1.612652 | |
| 51 | +272.80518 | 4.29657 | 1.000000 | (Rn2) |
| 52 | +318.81215 | 35.65154 | 1.488581 | |
| 53 | -904.77148 | 0.50000 | 1.000000 | |
| 54 | +231.59428 | 28.30000 | 1.488581 | |
| 55 | +851.03579 | 0.50000 | 1.000000 | |
| 56 | +163.97092 | 28.20000 | 1.488581 | |
| 57 | +322.06954 | 0.50000 | 1.000000 | |
| 58 | +140.43124 | 42.06842 | 1.488581 | |
| 59 | +1885.70600 | 0.80000 | 1.000000 | |
| 60 | +1890.45700 | 21.50825 | 1.612652 | |
| 61 | +83.55412 | 23.58350 | 1.000000 | (Rn3) |
| 62 | +91.71370 | 62.13512 | 1.615481 | |
| 63 | +748.85306 | (WD) | 1.000000 | (R5g) |

Table 8

| Conditions Corresponding to Values of Embodiment 4 | |
|---|---|
| (1) | f1/L = 0.148 |
| (2) | -f2/L = 0.050 |
| (3) | f3/L = 0.176 |
| (4) | -f4/L = 0.055 |
| (5) | f5p/L = 0.125 |
| (6) | f5g/L = 0.136 |
| (7) | R5g/L = 0.624 |
| (8) | -Rn1/L = 0.221 |
| (9) | (r1 + r2)/(r1-r2) = 0.479 (L55) |
| | (r1 + r2)/(r1-r2) = 1.748 (L56) |
| | (r1 + r2)/(r1-r2) = 3.074 (L57) |
| | (r1 + r2)/(r1-r2) = 1.168 (L58) |
| | (r1 + r2)/(r1-r2) = 1.279 (G5g) |
| (10) | Rn2/L = 0.227 |
| (11) | Rn3/L = 0.069 |
| (12) | -Rp1/L = 0.345 |

As is clear from the various values of each embodiment shown above, the projection optical system of Embodiments 1 through 4 provides a large numerical aperture while maintaining a wide exposure range.

Figures 4, 7, 10 and 13 are diagrams showing longitudinal aberrations of the projection optical system of Embodiments 1 through 4, respectively. Figures 5, 8, 11 and 14 are diagrams showing transverse (lateral)aberrations in the tangential and sagittal directions. In each of the aberration diagrams, NA denotes the numerical aperture of a projection optical system, and Y denotes the image height. In astigmatism diagrams, dotted lines denote the tangential image plane and a solid line denotes a sagittal image plane.

Comparing each of the aberration diagrams, it is clear that various aberrations are corrected uniformly in each of the embodiments, more specifically, various aberrations in all wide exposure regions are excellently corrected.

Note that i-line of ultraviolet radiation were used as the light source in each of the embodiments above. However, this does not limit the application of the apparatus incorporating the principles of the present invention. An extreme ultraviolet light source such as a 193 nm or 248.8 nm excimer laser and the like, a mercury arc lamp which supplies a g-line (435.8 nm) or h-line (404.7 nm) laser, or another light source which supplies radiation in the ultraviolet region may be used.

As described above, a high performance projection optical system incorporating the principles of the present invention excellently corrects various aberrations, especially distortions, while maintaining a large numerical aperture number and a wide exposure region with bitelecentricity.

If the projection optical system incorporating the principles of the present invention is applied to a projection exposure apparatus, an extremely precise circuitry pattern can be formed on wide exposure regions on a wafer.

**Claims**

**1.** A projection optical system in which an image of a first object is printed onto a second object, the system comprising in order from the first object side:

a first lens group having a positive refractive power with at least three positive lenses;

a second lens group having a negative refractive power with at least three negative lenses and one positive lens;

a third lens group having a positive refractive power with at least three positive lenses and one negative lens;

a fourth lens group having a negative refractive power with at least three negative lenses; and

a fifth lens group having a positive refractive power with at least six positive lenses and one negative lens,

**characterized in that**:

the first lens group has a subgroup G-1p having at least two positive lenses;

the second lens group has a subgroup G-2n having eat least three negative lenses;

the third lens group has a subgroup G-3p having at least three positive lenses;

the fourth lens group has as subgroup G4n having at least three negative lenses;

the fifth lens group has a subgroup G-5p having at least five positive lenses and a positive lens G5g with a concave surface R5g facing the second object side and being closer to the second object side than the subgroup G-5p, the fifth lens group further having a first concave surface N1 facing the first object side, a second concave surface N2 facing the second object side, and a third concave surface N3 facing the second object side, the third concave surface N3, being closer to the second object side than the second concave. surface N2, and the first, the second, and the third concave surfaces being formed on negative lenses;

wherein, the system satisfies the following conditions:

$$0.08 < f1/L < 0.25$$

$$0.03 < f2/L < 0.1$$

$$0.08 < f3/L < 0.3$$

$$0.035 < -f4/L < 0.11$$

$$0.1 < f5p/L < 0.25$$

$$0.07 < f5g/L < 0.21$$

$$0.25 < R5g/L < 0.83$$

$$0.125 < -Rn1/L < 0.33$$

$$0.16 < Rn2/L < 0.38$$

$$0.055 < Rn3/L < 0.09$$

where

L is the distance from the first object of the second object;
f1 is the focal length of the subgroup G-1p of the first lens group;
f2 is the focal length of the subgroup G-2n of the second lens group;
f3 is the focal length of the subgroup G-3p of the third lens group;
f4 is the focal length of the subgroup G-4n of the fourth lens group;
f5p is the focal length of the subgroup G5p of the fifth lens group;
R5g is the radius of curvature of the concave surface of the positive lens G5g facing the second object side;
Rn1 is the radius of the curvature of the first concave surface N1;
Rn2 is the radius of curvature of the second concave surface N2; and
Rn3 is the radius of curvature of the third concave surface N3.

2. A projection optical system, as set forth in claim 1, wherein at least four of the positive lenses in the fifth lens group satisfy the following equation:

$$-10 < (r1 + r2) / (r1 - r2) < -0.1$$

where:

r1 is the radius of curvature on the first object side of the at least four positive lenses; and
r2 is a radius of curvature on the second object side of the at least four positive lenses.

3. A projection optical system, as set forth in any one of claims 1 or 2, wherein said second lens group comprises at least one positive lens which satisfies the following equation when a radius of curvature of the surface facing said second object side of said positive lens of said second lens group is Rp1:

$$0.23 < -Rp1 / L < 0.5.$$

4. A projection optical system, as set forth in claim 3, wherein said positive lens of said second lens group is arranged closer to said first object side than said subgroup G-2n of said second lens group.

5. A projection optical system, as set forth in any one of claims 1, 2, 3, or 4, wherein said negative lens of said third lens group is arranged closer to said first object side than said subgroup G-3p of said third lens group.

6. A projection optical system, as set forth in any one of claims 1, 2, 3, 4, or 5, wherein the fourth lensgroup having a first lens with a convex surface facing to the first object side, and a second lens with a convex surface facing to the second object side, the first lens is arranged closer to the first object side of the lenses belonging to the fourth lens group, and the second lens is arranged closer to the second, object side among the lenses belonging to the fourth lens group.

7. A projection optical system, as set forth in claims 1 or 3, wherein said second lens group comprises a positive lens arranged at the first object side of said second lens group and wherein the subgroup G-2n of the second lens group is arranged at the second object side of said second lens group.

8. A projection optical system, as set forth in any one of claims 3 and 7, wherein said first and second concave surfaces N1 and N2 in said fifth lens group are arranged in said subgroup G-5p in said fifth lens group.

9. A projection optical system, as set forth in any one of claims 1 through 8, wherein said subgroup G-1p in said first lens group is comprised of positive lenses only.

10. A projection optical system, as set forth in any one of claims 1 through 9, wherein said subgroup G-2n of said second lens group is comprised of negative lenses only.

11. A projection optical system, as set forth in any one of claims 1 through 10, wherein said subgroup G-3p of said third lens group is comprised of positive lenses only.

12. A projection optical system, as set forth in any one of claims I through 11, wherein said subgroup G-4n of said fourth lens group is comprised of negative lenses only.

13. A projection optical system, as set forth in any one of claims 1 through 12, wherein said positive lens G-5g of said fifth lens group is a lens component which is arranged closest to said second object side.

14. A projection optical system, as set forth in any one of claims 1 through 13, wherein said system further comprises:

an illumination optical system which illuminates said first object;

a first support member which supports said first object; and

a second support member which supports said second object.

15. A method of manufacturing a device using a projection optical system, as set forth in any one of claims 1 through 13, comprising the steps of:

illuminating a mask with exposure light in the ultraviolet range, said mask having a predetermined circuit pattern drawn thereon; and

forming an image of said pattern of said illuminated mask onto a substrate by means of said projection optical system.

16. An exposure apparatus for forming a predetermined circuit pattern, having the projection optical system, as set forth in any one of claims 1 through 13, comprising:

an illuminating system for supplying exposure light in the ultraviolet range;

a first stage for holding said first object; and

a second stage for holding said second object.

17. An exposure apparatus as set forth in claim 16, further comprising means for scanning said first and second stage during exposure.

18. A method of imaging an image of a predetcrmined circuit pattern of a first object onto a second object, comprising:

illuminating the first object with exposure light in the ultraviolet range; and

imaging said image of said pattern using the projection optical system, as set forth in any one of claims 1 through 13.

**Patentansprüche**

1.  Optisches Projektionssystem, bei dem ein Bild eines ersten Objekts oder Gegenstandes auf ein zweites Objekt bzw. einen zweiten Gegenstand gedruckt oder abgebildet wird, wobei das System in der Reihenfolge von der Seite des ersten Gegenstandes aus gesehen Folgendes aufweist:

    eine erste Linsengruppe mit einer positiven Brechkraft mit mindestens drei positiven oder Sammellinsen;
    eine zweite Linsengruppe mit negativer Brechkraft mit mindestens drei negativen oder Streulinsen und einer positiven oder Sammellinse;
    eine dritte Linsengruppe mit einer positiven Brechkraft mit mindestens drei positiven oder Sammellinsen und einer negativen oder Streulinse; eine vierte Linsengruppe mit einer negativen Brechkraft mit mindestens drei negativen oder Streulinsen; und
    eine fünfte Linsengruppe mit einer positiven Brechkraft mit mindestens sechs positiven oder Sammellinsen und einer negativen oder Streulinse,

    **dadurch gekennzeichnet, dass**
    die erste Linsengruppe eine Untergruppe G-1 p mit mindestens zwei positiven oder Sammellinsen besitzt;
    die zweite Linsengruppe eine Untergruppe G-2n mit mindestens drei negativen oder Streulinsen besitzt;
    die dritte Linsengruppe eine Untergruppe G-3p mit mindestens drei positiven oder Sammellinsen besitzt;
    die vierte Linsengruppe eine Untergruppe G-4n mit mindestens drei negativen oder Streulinsen besitzt;
    die fünfte Linsengruppe eine Untergruppe G-5p mit mindestens fünf positiven oder Sammellinsen besitzt sowie eine positive Linse G5g besitzt, und zwar mit einer konkaven Oberfläche R5g, die zu der Seite des zweiten Gegenstandes hin weist, wobei die positive oder Sammellinse G5g näher zu der Seite des zweiten Gegenstandes hin angeordnet ist als die Untergruppe G-5p, wobei die fünfte Linsengruppe ferner eine erste konkave Oberfläche N1, die zur Seite des ersten Gegenstandes hin weist, eine zweite konkave Oberfläche N2, die zur Seite des zweiten Gegenstandes hin weist, und eine dritte konkave Oberfläche N3, die zur Seite des zweiten Gegenstandes hin weist, aufweist,
    wobei die dritte konkave Oberfläche N3 näher zu der Seite des zweiten Gegenstandes hin angeordnet ist als die zweite konkave Oberfläche N2, und wobei die erste, die zweite und die dritte konkave Oberfläche auf negativen oder Streulinsen gebildet sind;
    wobei das System die folgenden Bedingungen erfüllt:

$$0{,}08 < f1/L < 0{,}25$$

$$0{,}03 < f2/L < 0{,}1$$

$$0{,}08 < f3/L < 03$$

$$0{,}035 < -f4/L < 0{,}11$$

$$0{,}1 < f5p/L < 0{,}25$$

$$0{,}07 < f5g/L < 0{,}21$$

$$0{,}25 < R5g/L < 0{,}83$$

$$0,125 < -Rn1/L < 0,33$$

$$0,16 < Rn2/L < 0,38$$

$$0,055 < Rn3/L < 0,09$$

wobei:

L der Abstand des zweiten Gegenstandes vom ersten Gegenstand ist;
f1 die Brennweite der Untergruppe G-1 p der ersten Linsengruppe ist;
f2 die Brennweite der Untergruppe G-2n der zweiten Linsengruppe ist;
f3 die Brennweite der Untergruppe G-3p der dritten Linsengruppe ist;
f4 die Brennweite der Untergruppe G-4n der vierten Linsengruppe ist;
f5p die Brennweite der Untergruppe G-5p der fünften Linsengruppe ist;
R5g der Krümmungsradius der konkaven Oberfläche der positiven oder Sammellinse G5g ist, die zu der Seite des zweiten Gegenstandes hin weist;
Rn1 der Krümmungsradius der ersten konkaven Oberfläche N1 ist;
Rn2 der Krümmungsradius der zweiten konkaven Oberfläche N2 ist; und
Rn3 der Krümmungsradius der dritten konkaven Oberfläche N3 ist.

**2.** Optisches Projektionssystem gemäß Anspruch 1, wobei mindestens vier der positiven oder Sammellinsen in der fünften Linsengruppe die folgende Gleichung erfüllen:

$$-10 < (r1 + r2) / (r1 - r2) < -0,1$$

wobei:

r1    der Krümmungsradius der mindestens vier positiven oder Sammellinsen auf der Seite des ersten Gegenstandes ist, und
r2    der Krümmungsradius der mindestens vier positiven oder Sammellinsen auf der Seite des zweiten Gegenstandes ist.

**3.** Optisches Projektionssystem gemäß einem der Ansprüche 1 oder 2, wobei die zweite Linsengruppe mindestens eine positive oder Sammellinse aufweist, die die folgende Gleichung erfüllt, wenn ein Krümmungsradius der zu der Seite des zweiten Gegenstandes hin weisenden Oberfläche der positiven oder Sammellinse der zweiten Linsengruppe Rp1 ist:

$$0,23 < -Rp1 / L < 0,5$$

**4.** Optisches Projektionssystem gemäß Anspruch 3, wobei die positive oder Sammellinse der zweiten Linsengruppe näher zu der Seite des ersten Gegenstandes angeordnet ist als die Untergruppe G-2n der zweiten Linsengruppe.

**5.** Optisches Projektionssystem gemäß einem der Ansprüche 1, 2, 3 oder 4, wobei die negative oder Streulinse der dritten Linsengruppe näher zu der Seite des ersten Gegenstandes angeordnet ist als die Untergruppe G-3p der dritten Linsengruppe.

**6.** Optisches Projektionssystem gemäß einem der Ansprüche 1, 2, 3, 4 oder 5, wobei die vierte Linsengruppe eine erste Linse mit einer konvexen Oberfläche besitzt, die zu der Seite des ersten Gegenstandes hin weist, und eine zweite Linse mit einer konvexen Oberfläche, besitzt, die zu der Seite des zweiten Gegenstandes hin weist, wobei die erste Linse von den zu der vierten Linsengruppe gehörenden Linsen näher zu der Seite des ersten Gegenstandes angeordnet ist, und wobei die zweite Linse von den zu der vierten Linsengruppe gehörenden Linsen näher zu der Seite des zweiten Gegenstandes hin angeordnet ist.

**7.** Optisches Projektionssystem gemäß Anspruch 1 oder 3, wobei die zweite Linsengruppe eine positive oder Sammellinse aufweist, die an der Seite des ersten Gegenstandes der zweiten Linsengruppe angeordnet ist, und wobei die Untergruppe G-2n der zweiten Linsengruppe an der Seite des zweiten Gegenstandes der zweiten Linsengruppe angeordnet ist.

**8.** Optisches Projektionssystem gemäß einem der Ansprüche 3 oder 7, wobei die ersten und zweiten konkaven Oberflächen N1 und N2 in der fünften Linsengruppe in der Untergruppe G-5p in der fünften Linsengruppe angeordnet sind.

**9.** Optisches Projektionssystem gemäß einem der Ansprüche 1 bis 8, wobei die Untergruppe G-1p in der ersten Linsengruppe nur aus positiven oder Sammellinsen besteht.

**10.** Optisches Projektionssystem gemäß einem der Ansprüche 1 bis 9, wobei die Untergruppe G-2n der zweiten Linsengruppe nur aus negativen oder Streulinsen besteht.

**11.** Optisches Projektionssystem gemäß einem der Ansprüche 1 bis 10, wobei die Untergruppe G-3p der dritten Linsengruppe nur aus positiven oder Sammellinsen besteht.

**12.** Optisches Projektionssystem gemäß einem der Ansprüche 1 bis 11, wobei die Untergruppe G-4n der vierten Linsengruppe nur aus negativen oder Streulinsen besteht.

**13.** Optisches Projektionssystem gemäß einem der Ansprüche 1 bis 12, wobei die positive oder Sammellinse G5g der fünften Linsengruppe eine Linsenkomponente ist, die am nächsten zur Seite des zweiten Gegenstandes hin angeordnet ist.

**14.** Optisches Projektionssystem gemäß einem der Ansprüche 1 bis 13, wobei das System ferner Folgendes aufweist:

> ein optisches Beleuchtungssystem, das den ersten Gegenstand beleuchtet;
> ein erstes Tragglied, das den ersten Gegenstand trägt, und
> ein zweites Tragglied, das den zweiten Gegenstand trägt.

**15.** Verfahren zur Herstellung einer Einrichtung und Verwendung eines optischen Projektionssystems gemäß einem der Ansprüche 1 bis 13, wobei das Verfahren die folgenden Schritte aufweist:

> Beleuchten einer Maske mit Belichtungslicht im ultravioletten Bereich,

> wobei die Maske ein vorbestimmtes Schaltungsmuster darauf gezeichnet aufweist; und
> Bilden eines Bildes bzw. Abbilden des Musters der beleuchteten Maske auf einem Substrat anhand des optischen Projektionssystems.

**16.** Belichtungsvorrichtung zum Bilden eines vorbestimmten Schaltungsmusters mit dem optischen Projektionssystem gemäß einem der Ansprüche 1 bis 13, wobei die Vorrichtung Folgendes aufweist:

> ein Beleuchtungssystem zum Liefern von Belichtungslicht im ultravioletten Bereich;
> eine erste Bühne zum Halten des ersten Objekts oder Gegenstands; und
> eine zweite Bühne zum Halten des zweiten Objekts oder Gegenstands.

**17.** Belichtungsvorrichtung gemäß Anspruch 16, die ferner Mittel zum Scannen der ersten und zweiten Bühne während der Belichtung aufweist.

**18.** Verfahren zum Abbilden eines Bildes eines vorbestimmten Schaltungsmusters eines ersten Objekts oder Gegenstands auf ein zweites Objekt oder einen zweiten Gegenstand, wobei das Verfahren Folgendes aufweist:

> Beleuchten des ersten Objekts oder Gegenstandes mit Belichtungslicht im ultravioletten Bereich; und
> Abbilden des Bildes des Musters unter Verwendung des optischen Projektionssystems gemäß einem der Ansprüche 1 bis 13.

**Revendications**

1.  Système optique de projection dans lequel une image d'un premier objet est imprimée sur un deuxième objet, le système comprenant dans l'ordre à partir du coté du premier objet :

    -   un premier groupe de lentilles ayant une réfringence positive avec au moins trois lentilles positives ;
    -   un deuxième groupe de lentilles ayant une réfringence négative avec au moins trois lentilles négatives et une lentille positive ;
    -   un troisième groupe de lentilles ayant une réfringence positive avec au moins trois lentilles positives et une lentille négative ;
    -   un quatrième groupe de lentilles ayant une réfringence négative avec au moins trois lentilles négatives ; et
    -   un cinquième groupe de lentilles ayant une réfringence positive avec au moins six lentilles positives et une lentille négative ;

    **caractérisé en ce que** :,

    -   le premier groupe de lentilles possède un sous-groupe G-1p ayant au moins deux lentilles positives ;
    -   le deuxième groupe de lentilles possède un sous-groupe G-2n ayant au moins trois lentilles négatives ;
    -   le troisième groupe de lentilles possède un sous-groupe G-3p ayant au moins trois lentilles positives ;
    -   le quatrième groupe de lentilles possède un sous-groupe G4n ayant au moins trois lentilles négatives ;
    -   le cinquième groupe de lentilles possède un sous-groupe G-5p ayant au moins cinq lentilles positives et une lentille positive G5g avec une surface concave R5g tournée vers le coté du deuxième objet et étant plus près du coté du deuxième objet que le sous-groupe G-5p, le cinquième groupe de lentilles ayant de plus une première surface concave N1 tournée vers le côté du premier objet, une deuxième surface concave N2 tournée vers le côté du deuxième objet, et une troisième surface concave N3 tournée vers le côté du deuxième objet, la troisième surface concave N3, étant plus près du côté du deuxième objet que la deuxième surface concave N2, et les première, deuxième et troisième surfaces concaves étant formées sur des lentilles négatives ;

    dans lequel le système satisfait aux conditions suivantes :

    $$0,08 < f1/L < 0,25$$

    $$0,03 < f2/L < 0,1$$

    $$0,08 < f3/L < 0,3$$

    $$0,035 < -f4/L < 0,11$$

    $$0,1 < f5p/L < 0,25$$

    $$0,07 < f5g/L < 0,21$$

    $$0,25 < R5g/L < 0,83$$

    $$0,125 < -Rn1/L < 0,33$$

    $$0,16 < Rn2/L < 0,38$$

$$0,055 < Rn3/L < 0,09$$

où

L est la distance à partir du premier objet du deuxième objet ;

f1 est la longueur focale du sous-groupe G-1p du premier groupe de lentilles ;

f2 est la longueur focale du sous-groupe G-2n du deuxième groupe de lentilles ;

f3 est la longueur focale du sous-groupe G-3p du troisième groupe de lentilles ;

f4 est la longueur focale du sous-groupe G-4n du quatrième groupe de lentilles ;

f5p est la longueur focale du sous-groupe G5p du cinquième groupe de lentilles ;

R5g est le rayon de courbure de la surface concave de la lentille positive G5g tournée vers le coté du deuxième objet ;

Rn1 est le rayon de courbure de la première surface concave N1 ;

Rn2 est le rayon de courbure de la deuxième surface concave N2 ; et

Rn3 est le rayon de courbure de la troisième surface concave N3.

2. Système optique de projection selon la revendication 1, dans lequel au moins quatre des lentilles positives dans le cinquième groupe de lentilles satisfont à l'équation suivante :

$$- 10 < (r1 + r2)/(r1 - r2) < -0,1$$

où :

r1 est le rayon de courbure sur le coté du premier objet des au moins quatre lentilles positives ; et
r2 est un rayon de courbure sur le coté du deuxième objet des au moins quatre lentilles positives.

3. Système optique de projection selon l'une quelconque des revendications 1 ou 2, dans lequel ledit deuxième groupe de lentilles comprend au moins une lentille positive qui satisfait à l'équation suivante quand un rayon de courbure de la surface, tournée vers ledit coté du deuxième objet de ladite lentille positive dudit deuxième groupe de lentilles, est Rp1 :

$$0,23 < -Rp1/L < 0,5.$$

4. Système optique de projection selon la revendication 3, dans lequel ladite lentille positive dudit deuxième groupe de lentilles est disposée plus près dudit côté du premier objet que ledit sous-groupe G-2n dudit deuxième groupe de lentilles.

5. Système optique de projection selon l'une quelconque des revendications 1, 2, 3 ou 4, dans lequel ladite lentille négative dudit troisième groupe de lentilles est disposée plus près dudit côté du premier objet que ledit sous-groupe G-3p dudit troisième groupe de lentilles.

6. Système optique de projection selon l'une quelconque des revendications 1, 2, 3, 4 ou 5, dans lequel le quatrième groupe de lentilles ayant une première lentille avec une surface convexe tournée vers le côté du premier objet, et une deuxième lentille avec une surface convexe tournée vers le côté du deuxième objet, la première lentille est disposée plus près du côté du premier objet des lentilles appartenant au quatrième groupe de lentilles, et la deuxième lentille est disposée plus près du coté du deuxième objet parmi les lentilles appartenant au quatrième groupe de lentilles.

7. Système optique de projection selon les revendications 1 ou 3, dans lequel ledit deuxième groupe de lentilles comprend une lentille positive disposée au niveau du côté du premier objet dudit deuxième groupe de lentilles et dans lequel le sous-groupe G-2n du deuxième groupe de lentilles est disposé au niveau du côté du deuxième objet dudit deuxième groupe de lentilles.

8. Système optique de projection selon l'une quelconque des revendications 3 et 7, dans lequel lesdites première et deuxième surfaces concaves N1 et N2 dans ledit cinquième groupe de lentilles, sont disposées dans ledit sous-groupe G-5p dans ledit cinquième groupe de lentilles.

**9.** Système optique de projection selon l'une quelconque des revendications 1 à 8, dans lequel ledit sous-groupe G-1p dans ledit premier groupe de lentilles n'est constitué que de lentilles positives.

**10.** Système optique de projection selon l'une quelconque des revendications 1 à 9, dans lequel ledit sous-groupe G-2n dudit deuxième groupe de lentilles ne comprend que des lentilles négatives.

**11.** Système optique de projection selon l'une quelconque des revendications 1 à 10, dans lequel ledit sous-groupe G-3p dudit troisième groupe de lentilles ne comprend que des lentilles positives.

**12.** Système optique de projection selon l'une quelconque des revendications 1 à 11, dans lequel ledit sous-groupe G-4n dudit quatrième groupe de lentilles ne comprend que des lentilles négatives.

**13.** Système optique de projection selon l'une quelconque des revendications 1 à 12, dans lequel ladite lentille positive G-5g dudit cinquième groupe de lentilles est un composant de lentille qui est disposé le plus près dudit coté du deuxième objet.

**14.** Système optique de projection selon l'une quelconque des revendications 1 à 13, dans lequel ledit système comprend de plus :

- un système optique d'illumination qui illumine ledit premier objet ;
- un premier élément de support qui soutient ledit premier objet ; et
- un deuxième élément de support qui soutient ledit deuxième objet.

**15.** Procédé pour fabriquer un dispositif utilisant un système optique de projection selon l'une quelconque des revendications 1 à 13, comprenant les étapes consistant à :

- illuminer un masque avec une lumière d'exposition dans la gamme ultraviolette, ledit masque ayant un motif de circuit prédéterminé tracé dessus ; et
- former une image dudit motif dudit masque illuminé sur un substrat à l'aide dudit système optique de projection.

**16.** Appareil d'exposition pour former un motif de circuit prédéterminé, ayant le système optique de projection, selon l'une quelconque des revendications 1 à 13, comprenant :

- un système d'illumination pour fournir une lumière d'exposition dans la gamme ultraviolette;
- une première platine pour tenir ledit premier objet ; et
- une deuxième platine pour tenir ledit deuxième objet.

**17.** Appareil d'exposition selon la revendication 16, comprenant de plus des moyens pour déplacer en balayage lesdites première et deuxième platines pendant l'exposition.

**18.** Procédé pour imager une image d'un motif de circuit prédéterminé d'un premier objet sur un deuxième objet comprenant les étapes consistant à :

- illuminer le premier objet avec une lumière d'exposition dans la gamme ultraviolette ; et
- imager ladite image dudit motif en utilisant le système optique de projection selon l'une quelconque des revendications 1 à 13.

FIG. 1

FIG. 2

FIG. 3

EP 0 877 271 B1

FIG. 4

TANGENTIAL                SAGITTAL

0.0100          Y=15.6        0.0100

−0.0100                      −0.0100

0.0100          Y=11.7        0.0100

−0.0100                      −0.0100

0.0100          Y=7.8         0.0100

−0.0100                      −0.0100

0.0100          Y=3.9         0.0100

−0.0100                      −0.0100

0.0100          Y=0.0         0.0100

−0.0100                      −0.0100

FIG. 5

FIG. 6

SPHERICAL
ABERRATION

NA=0.615

−0.01      +0.01

ASTIGMATISM

Y=15.6

−0.01      +0.01

DISTORTION

Y=15.6

−0.001(%)      +0.001(%)

FIG. 7

EP 0 877 271 B1

34

TANGENTIAL　　　　　SAGITTAL

0.0100　　　Y=15.6　　0.0100

−0.0100　　　　　−0.0100

0.0100　　　Y=11.7　　0.0100

−0.0100　　　　　−0.0100

0.0100　　　Y=7.8　　0.0100

−0.0100　　　　　−0.0100

0.0100　　　Y=3.9　　0.0100

−0.0100　　　　　−0.0100

0.0100　　　Y=0.0　　0.0100

−0.0100　　　　　−0.0100

FIG. 8

FIG. 9

SPHERICAL
ABERRATION

NA=0.615

−0.01        +0.01

ASTIGMATISM

Y=15.6

−0.01        +0.01

DISTORTION

Y=15.6

−0.001(%)        +0.001(%)

FIG. 10

EP 0 877 271 B1

TANGENTIAL

SAGITTAL

0.0100     Y=15.6     0.0100

−0.0100     −0.0100

0.0100     Y=11.7     0.0100

−0.0100     −0.0100

0.0100     Y=7.8     0.0100

−0.0100     −0.0100

0.0100     Y=3.9     0.0100

−0.0100     −0.0100

0.0100     Y=0.0     0.0100

−0.0100     −0.0100

FIG. 11

FIG. 12

FIG. 13

TANGENTIAL

SAGITTAL

FIG. 14